# EUROPEAN PATENT APPLICATION

(11) **EP 4 478 410 A1**
(43) Date of publication of application: **18.12.2024**
(21) Application number: 22927490.7
(22) Date of filing: 21.02.2022
(51) Int. Cl.: H01L 25/075, H01L 33/38, H01L 33/62, H01L 33/40, H01L 27/12

(54) **LIGHT-EMITTING ELEMENT PACKAGE AND DISPLAY DEVICE**

(71) Applicant: LG Electronics Inc., Yeongdeungpo-gu Seoul 07336 (KR)
(72) Inventor: CHOI, Bongseok, Seoul 06772 (KR); MOON, Joonkwon, Seoul 06772 (KR); PARK, Sungjin, Seoul 06772 (KR); KIM, Soohyun, Seoul 06772 (KR); OH, Taesu, Seoul 06772 (KR)
(74) Representative: Vossius & Partner Patentanwälte Rechtsanwälte mbB
(86) International application number: PCT/KR2022/095034
(87) International publication number: WO 2023/158094

(57) **Abstract**

A light-emitting element package can include a first layer having an oval shape, a first semiconductor light-emitting element group on the first layer, a first electrode pad group on the first layer, and a second electrode pad group on the first layer.

The first layer can have a first region comprising an oval major axis, a second region contacting the first region on one side of the oval major axis, and a third region contacting the first region on the other side of the oval major axis. The first semiconductor light-emitting element group can be disposed on the first region and can include a plurality of semiconductor light-emitting elements. The first electrode pad group can be disposed on the second region and can include a plurality of electrode pads. The second electrode pad group can be disposed on the third region and can include a plurality of redundancy electrode pads.

## Description

### [Technical Field]

The embodiment relates to a light-emitting element package and a display device.

### [Background Art]

Large-area displays include liquid crystal displays (LCDs), OLED displays, and micro-LED displays.

A micro-LED display is a display that uses a micro-LED, which is a semiconductor light-emitting element having a diameter or cross-sectional area of 100µm or less, as a display element.

Since the micro-LED display uses a micro-LED, which is a semiconductor light-emitting element, as a display element, it has excellent performance in many characteristics such as contrast ratio, response speed, color reproducibility, viewing angle, brightness, resolution, lifespan, luminous efficiency, or luminance.

In particular, the micro-LED display has the advantage of being able to freely adjust the size and resolution by separating and combining the screen in a modular manner, and of being able to implement a flexible display.

However, since the large micro-LED display requires millions or more micro-LEDs, there is a technical problem that makes it difficult to quickly and accurately transfer micro-LEDs to the display panel.

Recently-developed transfer technologies include the pick and place process method, the laser lift-off method, or the self-assembly method.

Among these, the self-assembly method is a method in which semiconductor light-emitting elements find their assembly positions within a fluid, which is advantageous for implementing large-screen display devices.

However, research on the technology for manufacturing displays through self-assembly of micro-LEDs is still insufficient.

In particular, in the case of rapidly transferring millions or more semiconductor light-emitting elements to a large display in the conventional related art, the transfer speed can be improved, but the transfer error rate increases, which causes a technical problem in that the transfer yield decreases.

In the related technology, a self-assembly method using dielectrophoresis (DEP) is being attempted, but there is a problem that the self-assembly rate is low due to the non-uniformity of the DEP force.

On the other hand, in the self-assembly method, since the red light-emitting element, the green light-emitting element, and the blue light-emitting element are individually injected, assembled, and recovered, there is a problem that the process time is very long. In addition, when a light-emitting element that was not recovered in the previous process is assembled with another light-emitting element, there is a problem that it is difficult to implement full color because the light-emitting element that emits light of different color are assembled in a specific color area, causing color mixing.

In order to shorten the process time, a self-assembly method that simultaneously assembles the red light-emitting elements, the green light-emitting elements, and the blue color light-emitting elements has been proposed. In order to implement this self-assembly method, the shape and size of each of the red light-emitting element, the green light-emitting element, and the blue light-emitting element are different. Since the shapes and sizes of the red light-emitting element, the green light-emitting element, and the blue light-emitting element are different, the light amounts of the red light-emitting element, the green light-emitting element, and the blue light-emitting element are different from each other, which causes a problem in that the color reproducibility (color gamut) is reduced.

On the other hand, since the red light-emitting elements, the green light-emitting elements, and the blue light-emitting elements must be disposed in pixels of a display substrate, it is difficult to reduce the size of the pixels, making it difficult to implement ultra-high resolution.

### [Disclosure]

### [Technical Problem]

An object of the embodiment is to solve the foregoing and other problems.

Another object of the embodiment is to provide a light-emitting element package and a display device that can improve the assembly speed.

In addition, another object of the embodiment is to provide a light-emitting element package and a display device that can solve the problem of reduced color reproducibility.

In addition, another object of the embodiment is to provide a light-emitting element package and a display device that can implement ultra-high resolution.

The technical problems of the embodiments are not limited to those described in this item and include those that can be understood through the description of the invention.

### [Technical Solution]

According to one aspect of the embodiment, in order to achieve the above or other purposes, a light-emitting element package, comprises: a first layer having an oval shape; a first semiconductor light-emitting element group on the first layer; a first electrode pad group on the first layer; and a second electrode pad group on the first layer; wherein the first layer has a first region comprising a major axis of the oval shape, a second region contacting the first region on one side of the major axis of the oval shape, and a third region contacting the first region on the other side of the major axis of the oval shape, wherein the first semiconductor light-emitting element group is disposed on the first region and comprises a plurality of semiconductor light-emitting elements, wherein the first electrode pad group is disposed on the second region and comprises a plurality of electrode pads, and wherein the second electrode pad group is disposed on the third region and comprises a plurality of redundancy electrode pads.

At least one semiconductor light-emitting element among the plurality of semiconductor light-emitting elements can be disposed at the center of the first region, and the plurality of electrode pads and the plurality of redundancy electrode pads can be disposed to face each other with the at least one semiconductor light-emitting element as the center. The electrode pads and the redundancy electrode pads disposed to face each other can be connected to the same semiconductor light-emitting element.

The second region can have a first round side, and the third region has a second round side, and the first round side and the second round side can be symmetrical with respect to the major axis of the oval shape. The plurality of electrode pads can be disposed along the first round side on the second region, and the plurality of redundancy electrode pads can be disposed along the second round side on the third region.

Each of the plurality of electrode pads and each of the plurality of redundancy electrode pads can have a dot shape spaced apart from each other.

A second semiconductor light-emitting element group can be included in the first layer; and the second semiconductor light-emitting element group can be disposed on the first region and can comprise a plurality of redundancy semiconductor light-emitting elements. The plurality of redundancy semiconductor light-emitting elements can be disposed adjacent to the plurality of semiconductor light-emitting elements on the first region. The plurality of semiconductor light-emitting elements can be connected to the plurality of electrode pads, respectively and the plurality of redundancy semiconductor light-emitting elements can be be connected to the plurality of redundancy electrode pads, respectively.

A second layer can be included in the first semiconductor light-emitting element group, the first electrode pad group, and the second electrode pad group; and a metal layer can be included in the second layer. The metal layer may comprise a magnetic layer or a reflective layer.

According to another aspect of the embodiment, a display device, comprises a substrate comprising a plurality of grooves; a plurality of light-emitting element packages disposed respectively in the plurality of grooves; and a first signal line group disposed on one side of each of the plurality of grooves and comprising a plurality of signal lines, wherein the light-emitting element package comprises a first layer having an oval shape; a first semiconductor light-emitting element group on the first layer; a first electrode pad group on the first layer; and a second electrode pad group on the first layer, wherein the first layer has a first region comprising a major axis of the oval shape, a second region contacting the first region on one side of the major axis of the oval shape, and a third region contacting the first region on the other side of the major axis of the oval shape, wherein the first semiconductor light-emitting element group is disposed on the first region and comprises a plurality of semiconductor light-emitting elements, wherein the first electrode pad group is disposed on the second region and comprises a plurality of electrode pads, and wherein the second electrode pad group is disposed on the third region and comprises a plurality of redundancy electrode pads.

The display device can comprise a second signal line group disposed on the other side of each of the plurality of grooves and comprises a plurality of redundancy signal lines, the light-emitting element package can comprise a second semiconductor light-emitting element group on the first layer, the second semiconductor light-emitting element group can be disposed on the first region and comprises a plurality of redundancy semiconductor light-emitting elements, and the plurality of signal lines can be connected to the plurality of semiconductor light-emitting elements, respectively.

The major axis of the oval shape of the first layer can be parallel to the plurality of signal lines and the plurality of redundancy signal lines.

The plurality of semiconductor light-emitting elements can be disposed adjacent to the plurality of signal lines, and the plurality of redundancy semiconductor light-emitting elements can be disposed adjacent to the plurality of redundancy signal lines.

### [Advantageous Effects]

According to an embodiment, at least one semiconductor light-emitting element among a plurality of semiconductor light-emitting elements is disposed at the center of a first region of a first layer of a light-emitting element package, and a plurality of electrode pads and a plurality of redundancy electrode pads can be disposed to face each other with the at least one semiconductor light-emitting element as the center. In this case, the electrode pads and the redundancy electrode pads disposed to face each other can be connected to the same semiconductor light-emitting element. Therefore, even if the light-emitting element package is assembled normally or rotated 180 degrees in the groove of the substrate, a plurality of signal lines disposed on the substrate can be connected to the plurality of electrode pads or the plurality of redundancy electrode pads disposed to face each other with the semiconductor light-emitting element located at the center of the light-emitting element package. Therefore, since the plurality of semiconductor light-emitting elements of the light-emitting element package are always electrically connected to the plurality of signal lines disposed on the substrate regardless of the assembly directionality, it is possible to fundamentally block electrical connection failures that may be caused by the light-emitting element package having an oval shape.

According to the embodiment, since the groove of the light-emitting element package and the partition wall have an oval shape, when the light-emitting element package is assembled into the groove of the partition wall, rotation within the groove of the partition wall is prevented, thereby enhancing the fixation of the light-emitting element package.

According to an embodiment, when the light-emitting element package is assembled into the groove of the partition regardless of the direction in which it rotates during the self-assembly process, electrical connection is possible regardless of the assembly directionality, so that the degree of freedom in the assembly directionality can be maximized.

According to an embodiment, a light-emitting element package comprising a plurality of semiconductor light-emitting elements configuring one pixel is made in advance, and a display device is implemented by assembling the light-emitting element package by self-assembly, thereby dramatically improving the assembly speed and enabling mass production.

According to an embodiment, there is no need to individually assemble a plurality of semiconductor light-emitting elements emitting different color light by self-assembly, thereby preventing a decrease in color reproducibility and enabling full-color image implementation through color mixing prevention.

According to an embodiment, by disposing a light-emitting element package comprising a plurality of semiconductor light-emitting elements in one pixel, the pixel size can be reduced, thereby enabling implementation of ultra-high resolution.

According to the embodiment, by optimizing the arrangement layout of the plurality of semiconductor light-emitting elements and the plurality of electrode pads, the size of each of the plurality of semiconductor light-emitting elements can be expanded, and the luminance can be increased by the size expansion, thereby implementing a high-quality image.

Additional scope of applicability of the embodiments will become apparent from the detailed description that follows. However, since various changes and modifications within the spirit and scope of the embodiments may be clearly understood by those skilled in the art, the detailed description and specific embodiments, such as preferred embodiments, should be understood as being given by way of example only.

### [Description of Drawings]

FIG. 1 illustrates a living room of a house in which a display device according to the embodiment is disposed.
FIG. 2 is a block diagram schematically showing a display device according to the embodiment.
FIG. 3 is a circuit diagram showing an example of a pixel of FIG. 2.
FIG. 4 is an enlarged view of the first panel area of the display device of FIG. 1.
FIG. 5 is an enlarged view of the A2 area of FIG. 4.
FIG. 6 is a drawing showing an example of a light-emitting element according to an embodiment being assembled on a substrate by a self-assembly method.
FIG. 7 is a drawing illustrating a display device according to a first embodiment.
FIG. 8 is a cross-sectional view cut along the C1-C2 line of the display device according to the first embodiment of FIG. 7.
FIG. 9a is a plan view schematically showing a light-emitting element package according to the first embodiment.
FIG. 9b is a plan view detailing a light-emitting element package according to the first embodiment.
FIG. 10 is a cross-sectional view schematically showing a light-emitting element package according to the first embodiment.
FIG. 11 is a drawing illustrating a display device according to a second embodiment.
FIG. 12 is a cross-sectional view schematically showing a light-emitting element package according to the second embodiment.
FIGS. 13a to 13f are flowcharts explaining a manufacturing process of a light-emitting element package according to the second embodiment.
FIG. 14 is a cross-sectional view showing a display device equipped with a light-emitting element package according to the second embodiment.

The sizes, shapes, dimensions, etc. of elements shown in the drawings can differ from actual ones. In addition, even if the same elements are shown in different sizes, shapes, dimensions, etc. between the drawings, this is only an example on the drawing, and the same elements have the same sizes, shapes, dimensions, etc. between the drawings.

### [Mode for Invention]

Hereinafter, the embodiment disclosed in this specification will be described in detail with reference to the accompanying drawings, but the same or similar elements are given the same reference numerals regardless of reference numerals, and redundant descriptions thereof will be omitted. The suffixes 'module' and 'unit' for the elements used in the following descriptions are given or used interchangeably in consideration of ease of writing the specification, and do not themselves have a meaning or role that is distinct from each other. In addition, the accompanying drawings are for easy understanding of the embodiment disclosed in this specification, and the technical idea disclosed in this specification is not limited by the accompanying drawings. Also, when an element such as a layer, region or substrate is referred to as being 'on' another element, this means that there can be directly on the other element or be other intermediate elements therebetween.

The display device described in this specification may comprise a TV, a signage, a mobile phone, a smart phone, a head-up display (HUD) for a car, a backlight unit for a laptop computer, a display for VR or AR, etc. However, the configuration according to the embodiment described in this specification may also be applied to a device capable of displaying, even if it is a new product type developed in the future.

The following describes a light-emitting element according to an embodiment and a display device comprising the same.

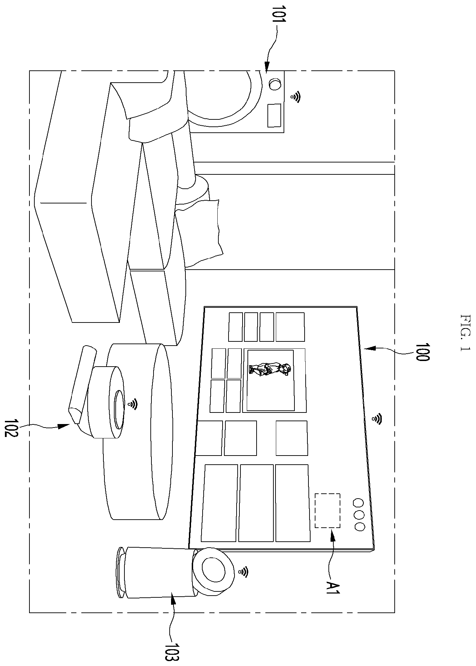

FIG. 1 illustrates a living room of a house in which a display device according to an embodiment is disposed.

Referring to FIG. 1, the display device 100 of the embodiment can display the status of various electronic products such as a washing machine 101, a robot vacuum cleaner 102, and an air purifier 103, and can communicate with each electronic product based on IOT and control each electronic product based on the user's setting data.

The display device 100 according to the embodiment may comprise a flexible display manufactured on a thin and flexible substrate. The flexible display may be bent or rolled like paper while maintaining the characteristics of a conventional flat panel display.

In the flexible display, visual information may be implemented by independently controlling the light emission of unit pixels disposed in a matrix form. A unit pixel means a minimum unit for implementing one color. The unit pixel of the flexible display may be implemented by a light-emitting element. In the embodiment, the light-emitting element may be a Micro-LED or a Nano-LED, but is not limited thereto.

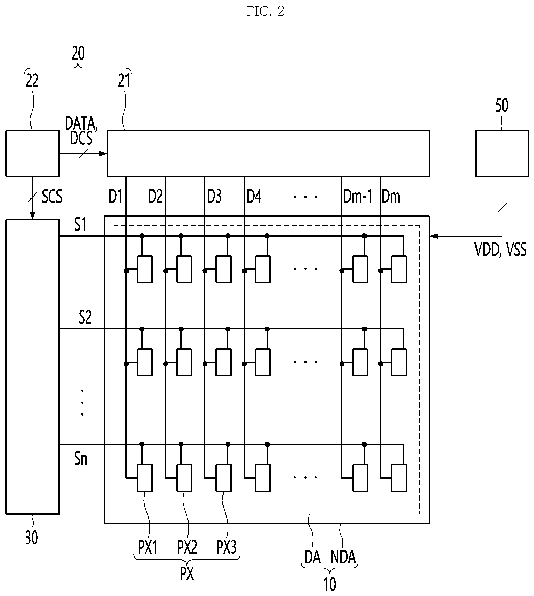

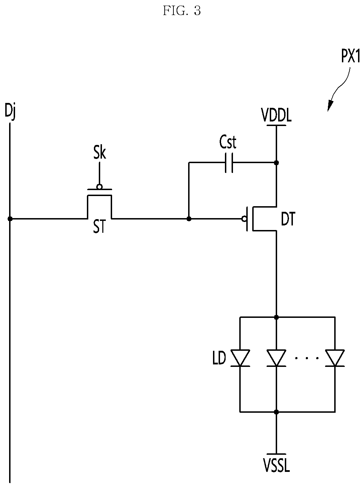

FIG. 2 is a block diagram schematically showing a display device according to the embodiment, and FIG. 3 is a circuit diagram showing an example of a pixel of FIG. 2.

Referring to FIGS. 2 and 3, the display device according to the embodiment may comprise a display panel 10, a driving circuit 20, a scan driving unit 30, and a power supply circuit 50.

The display device 100 of the embodiment can drive a light-emitting element in an active matrix (AM) method or a passive matrix (PM) method.

The driving circuit 20 can comprise a data driving unit 21 and a timing control unit 22.

The display panel 10 can be formed in a rectangular shape, but is not limited thereto. That is, the display panel 10 can be formed in a circular or oval shape. At least one side of the display panel 10 can be formed to be bent at a predetermined curvature.

The display panel 10 can be divided into a display area DA and a non-display area NDA disposed around the display area DA. The display area DA is an area where pixels PX are formed to display an image. The display panel 10 may comprise data lines (D1 to Dm, where m is an integer greater than or equal to 2), scan lines (S1 to Sn, where n is an integer greater than or equal to 2) intersecting the data lines D1 to Dm, a high-potential voltage line VDDL supplied with a high-potential voltage, a low-potential voltage line VSSL supplied with a low-potential voltage, and pixels PX connected to the data lines D1 to Dm and the scan lines S1 to Sn.

Each of the pixels PX may comprise a first sub-pixel PX1, a second sub-pixel PX2, and a third sub-pixel PX3. The first sub-pixel PX1 may emit a first color light of a first main wavelength, the second sub-pixel PX2 may emit a second color light of a second main wavelength, and the third sub-pixel PX3 may emit a third color light of a third main wavelength. The first color light may be red light, the second color light may be green light, and the third color light may be blue light, but is not limited thereto. In addition, although FIG. 2 exemplifies that each of the pixels PX comprises three sub-pixels, but is not limited thereto. That is, each of the pixels PX may comprise four or more sub-pixels.

Each of the first sub-pixel PX1, the second sub-pixel PX2, and the third sub-pixel PX3 may be connected to at least one of the data lines D1 to Dm, at least one of the scan lines S1 to Sn, and a high-potential voltage line VDDL. The first sub-pixel PX1 may comprise light-emitting elements LD, a plurality of transistors for supplying current to the light-emitting elements LD, and at least one capacitor Cst, as shown in FIG. 3.

Although not shown in the drawing, each of the first sub-pixel PX1, the second sub-pixel PX2, and the third sub-pixel PX3 may comprise only one light-emitting element LD and at least one capacitor Cst.

Each of the light-emitting elements LD may be a semiconductor light-emitting diode comprising a first electrode, a plurality of conductivity type semiconductor layers, and a second electrode. Here, the first electrode may be an anode electrode, and the second electrode may be a cathode electrode, but are not limited thereto.

The light-emitting element LD may be one of a lateral-type light-emitting element, a flip-chip light-emitting element, and a vertical-type light-emitting element.

The plurality of transistors may comprise a driving transistor DT for supplying current to the light-emitting elements LD, and a scan transistor ST for supplying a data voltage to a gate electrode of the driving transistor DT, as shown in FIG. 3. The driving transistor DT may comprise a gate electrode connected to a source electrode of the scan transistor ST, a source electrode connected to a high-potential voltage line VDDL to which a high-potential voltage is applied, and a drain electrode connected to the first electrodes of the light-emitting elements LD. The scan transistor ST may comprise a gate electrode connected to a scan line (Sk, where k is an integer satisfying 1 ≤ k ≤ n), a source electrode connected to the gate electrode of the driving transistor DT, and a drain electrode connected to a data line (Dj, where j is an integer satisfying 1 ≤ j ≤ m).

A capacitor Cst is formed between the gate electrode and the source electrode of the driving transistor DT. The storage capacitor Cst charges the difference between the gate voltage and the source voltage of the driving transistor DT.

The driving transistor DT and the scan transistor ST may be formed as thin film transistors. In addition, although FIG. 3 mainly describes the driving transistor DT and the scan transistor ST as formed as a P-type MOSFET (Metal Oxide Semiconductor Field Effect Transistor), but is not limited thereto. The driving transistor DT and the scan transistor ST may also be formed as an N-type MOSFET. In this case, the positions of the source electrode and the drain electrode of each of the driving transistor DT and the scan transistor ST may be changed.

In addition, in FIG. 3, the first sub-pixel PX1, the second sub-pixel PX2, and the third sub-pixel PX3 each comprise a 2T1C (2 Transistor - 1 capacitor) having one driving transistor DT, one scan transistor ST, and one capacitor Cst, but is not limited thereto. The first sub-pixel PX1, the second sub-pixel PX2, and the third sub-pixel PX3 each may comprise a plurality of scan transistors STs and a plurality of capacitors Csts.

Since the second sub-pixel PX2 and the third sub-pixel PX3 may be expressed in substantially the same circuit diagram as the first sub-pixel PX1, a detailed description thereof will be omitted.

The driving circuit 20 outputs signals and voltages for driving the display panel 10. To this end, the driving circuit 20 may comprise a data driving unit 21 and a timing control unit 22.

The data driving unit 21 receives digital video data DATA and a source control signal DCS from the timing control unit 22. The data driving unit 21 converts the digital video data DATA into analog data voltages according to the source control signal DCS and supplies the converted data to the data lines D1 to Dm of the display panel 10.

The timing control unit 22 receives digital video data DATA and timing signals from the host system. The timing signals may comprise a vertical synchronization signal, a horizontal synchronization signal, a data enable signal, and a dot clock. The host system may be an application processor of a smartphone or tablet PC, a monitor, a system on chip of a TV, etc.

The timing control unit 22 generates control signals for controlling the operation timing of the data driving unit 21 and the scan driving unit 30. The control signals may comprise a source control signal DCS for controlling the operation timing of the data driving unit 21 and a scan control signal SCS for controlling the operation timing of the scan driving unit 30.

The driving circuit 20 may be disposed in a non-display area NDA provided on one side of the display panel 10. The driving circuit 20 may be formed as an integrated circuit (IC) and may be mounted on the display panel 10 in a chip on glass (COG) manner, a chip on plastic (COP) manner, or an ultrasonic bonding manner, but is not limited thereto. For example, the driving circuit 20 may be mounted on a circuit board (not shown) other than the display panel 10.

The data driving unit 21 may be mounted on the display panel 10 in a chip on glass (COG) manner, a chip on plastic (COP) manner, or an ultrasonic bonding manner, and the timing control unit 22 may be mounted on a circuit board.

The scan driving unit 30 receives a scan control signal SCS from the timing controller 22. The scan driving unit 30 generates scan signals according to the scan control signal SCS and supplies the scan signals to the scan lines S1 to Sn of the display panel 10. The scan driving unit 30 may be formed in a non-display area NDA of the display panel 10 comprising a plurality of transistors. Alternatively, the scan driving unit 30 may be formed as an integrated circuit, in which case it may be mounted on a gate flexible film attached to the other side of the display panel 10.

The circuit board may be attached to pads provided on one side edge of the display panel 10 using an anisotropic conductive film. As a result, lead lines of the circuit board may be electrically connected to the pads. The circuit board may be a flexible film such as a flexible printed circuit board, a printed circuit board, or a chip on film. The circuit board may be bent to the lower side of the display panel 10. As a result, one side of the circuit board may be attached to one edge of the display panel 10, and the other side may be disposed at the lower side of the display panel 10 and connected to a system board on which a host system is mounted.

The power supply circuit 50 may generate voltages required for driving the display panel 10 from the main power applied from the system board and supply the voltages to the display panel 10. For example, the power supply circuit 50 may generate a high-potential voltage VDD and a low-potential voltage VSS for driving the light-emitting elements LD of the display panel 10 from the main power and supply the high-potential voltage VDD and the low-potential voltage VSS to the high-potential voltage line VDDL and the low-potential voltage line VSSL of the display panel 10. In addition, the power supply circuit 50 may generate and supply driving voltages for driving the driving circuit 20 and the scan driving unit 30 from the main power

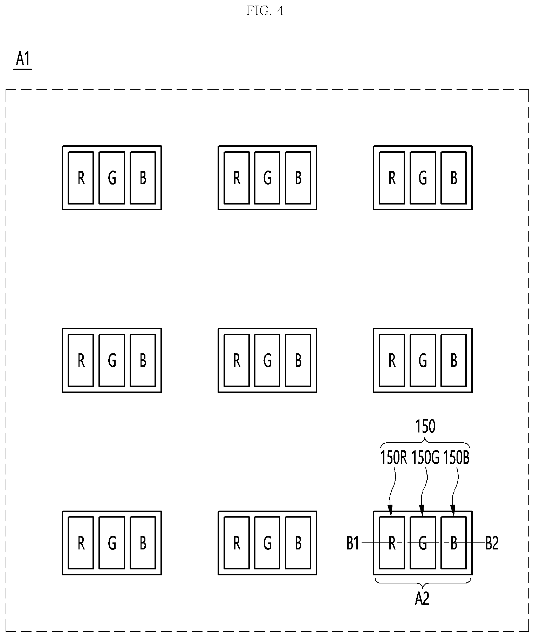

FIG. 4 is an enlarged view of the first panel area in the display device of FIG. 3.

Referring to FIG. 4, the display device 100 of the embodiment may be manufactured by mechanically and electrically connecting a plurality of panel areas, such as the first panel area A1, by tiling.

The first panel area A1 may comprise a plurality of semiconductor light-emitting elements 150 disposed for each unit pixel (PX of FIG. 2).

For example, the unit pixel PX may comprise a first sub-pixel PX1, a second sub-pixel PX2, and a third sub-pixel PX3. For example, a plurality of red semiconductor light-emitting elements 150R may be disposed in the first sub-pixel PX1, a plurality of green semiconductor light-emitting elements 150G may be disposed in the second sub-pixel PX2, and a plurality of blue semiconductor light-emitting elements 150B may be disposed in the third sub-pixel PX3. The unit pixel PX may further comprise a fourth sub-pixel in which no semiconductor light-emitting elements are disposed, but is not limited thereto.

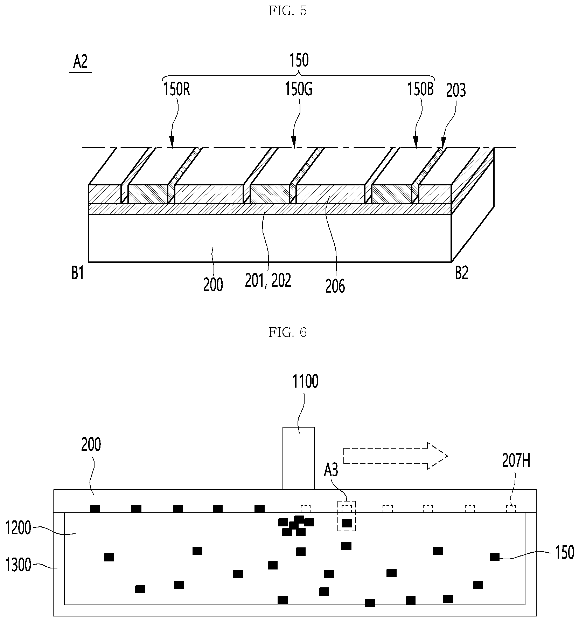

FIG. 5 is an enlarged view of the A2 region of FIG. 4.

Referring to FIG. 5, the display device 100 of the embodiment may comprise a substrate 200, assembling wirings 201 and 202, an insulating layer 206, and a plurality of semiconductor light-emitting elements 150. More components may be included than these.

The assembling wiring may comprise a first assembling wiring 201 and a second assembling wiring 202 that are spaced apart from each other. The first assembling wiring 201 and the second assembling wiring 202 may be provided to generate a dielectrophoretic force (DEP force) to assemble the semiconductor light-emitting element 150. For example, the semiconductor light-emitting element 150 may be one of a lateral-type semiconductor light-emitting element, a flip-chip type semiconductor light-emitting element, and a vertical-type semiconductor light-emitting element.

The semiconductor light-emitting element 150 may comprise, but is not limited to, a red semiconductor light-emitting element 150R, a green semiconductor light-emitting element 150G, and a blue semiconductor light-emitting element 150B to form a unit pixel (sub-pixel), and may also comprise a red phosphor and a green phosphor to implement red and green, respectively.

The substrate 200 may be a support member that supports components disposed on the substrate 200 or a protective member that protects the components.

The substrate 200 may be a rigid substrate or a flexible substrate. The substrate 200 may be formed of sapphire, glass, silicon, or polyimide. In addition, the substrate 200 may comprise a flexible material such as polyethylene naphthalate (PEN), polyethylene terephthalate (PET). In addition, the substrate 200 may be a transparent material, but is not limited thereto. The substrate 200 can function as a support substrate in the display panel, and can also function as an assembling substrate when self-assembling the light-emitting element.

The substrate 200 can be a backplane equipped with circuits, such as transistors ST and DT, capacitors Cst, and signal wiring, within the sub-pixels PX1, PX2, and PX3 illustrated in FIGS. 2 and 3, but is not limited thereto.

The insulating layer 206 can comprise an organic material having insulation and flexibility, such as polyimide, PAC, PEN, PET, polymer, or an inorganic material, such as silicon oxide (SiO₂) or silicon nitride series (SiNₓ), and can be formed integrally with the substrate 200 to form a single substrate.

The insulating layer 206 may be a conductive adhesive layer having adhesiveness and conductivity, and the conductive adhesive layer may have flexibility to enable a flexible function of the display device. For example, the insulating layer 206 may be a conductive adhesive layer such as an anisotropic conductive film (ACF) or an anisotropic conductive medium, a solution containing conductive particles, etc. The conductive adhesive layer may be a layer that is electrically conductive in a direction vertical to the thickness, but electrically insulating in a direction horizontal to the thickness.

The insulating layer 206 may comprise an assembly hole 203 for inserting the semiconductor light-emitting element 150. Therefore, during self-assembly, the semiconductor light-emitting element 150 may be easily inserted into the assembly hole 203 of the insulating layer 206. The assembly hole 203 may be called an insertion hole, a fixing hole, an alignment hole, etc. The assembly hole 203 may also be called a hole.

The assembly hole 203 may be called a hole, a groove, a recess, a pocket, etc.

The assembly hole 203 may vary depending on the shape of the semiconductor light-emitting element 150. For example, the red semiconductor light-emitting element, the green semiconductor light-emitting element, and the blue semiconductor light-emitting element each have different shapes, and may have an assembly hole 203 having a shape corresponding to the shape of each of these semiconductor light-emitting elements. For example, the assembly hole 203 may comprise a first assembly hole for assembling the red semiconductor light-emitting element, a second assembly hole for assembling the green semiconductor light-emitting element, and a third assembly hole for assembling the blue semiconductor light-emitting element. For example, the red semiconductor light-emitting element may have a circular shape, the green semiconductor light-emitting element may have a first oval shape having a first minor axis and a second major axis, and the blue semiconductor light-emitting element may have a second oval shape having a second minor axis and a second major axis, but is not limited thereto. The second major axis of the oval shape of the blue semiconductor light-emitting element may be greater than the second major axis of the oval shape of the green semiconductor light-emitting element, and the second minor axis of the oval shape of the blue semiconductor light-emitting element may be smaller than the first minor axis of the oval shape of the green semiconductor light-emitting element.

Meanwhile, the method of mounting the semiconductor light-emitting element 150 on the substrate 200 may comprise, for example, a self-assembly method (FIG. 6) and a transfer method.

FIG. 6 is a drawing showing an example of assembling a light-emitting element according to an embodiment on a substrate by a self-assembly method.

Based on FIG. 6, an example of assembling a semiconductor light-emitting element according to an embodiment on a display panel by a self-assembly method using an electromagnetic field will be described.

The assembling substrate 200 described below can also function as a panel substrate 200a in a display device after assembling the light-emitting element, but the embodiment is not limited thereto.

Referring to FIG. 6, the semiconductor light-emitting element 150 can be put into a chamber 1300 filled with a fluid 1200, and the semiconductor light-emitting element 150 can move to the assembling substrate 200 by a magnetic field generated from the assembly device 1100. At this time, the light-emitting element 150 adjacent to the assembly hole 207H of the assembling substrate 200 can be assembled into the assembly hole 207H by the DEP force due to the electric field of the assembling wirings. The fluid 1200 may be water such as ultrapure water, but is not limited thereto. The chamber may be called a tank, a container, a vessel, etc.

After the semiconductor light-emitting element 150 is put into the chamber 1300, the assembling substrate 200 may be disposed on the chamber 1300. According to an embodiment, the assembling substrate 200 may be put into the chamber 1300.

The assembling substrate 200 may comprise a pair of first assembling wirings 201 and second assembling wirings 202 corresponding to each of the semiconductor light-emitting elements 150 to be assembled. Each of the first assembling wirings 201 and the second assembling wirings 202 may be formed by multiply laminating a single metal, a metal alloy, a metal oxide, etc. For example, each of the first assembling wiring 201 and the second assembling wiring 202 may be formed by comprising at least one of Cu, Ag, Ni, Cr, Ti, Al, Rh, Pd, Ir, Ru, Mg, Zn, Pt, Au, and Hf, but is not limited thereto.

The first assembling wiring 201 and the second assembling wiring 202 may form an electric field when an AC voltage is applied, and the semiconductor light-emitting element 150 inserted into the assembly hole 207H may be fixed by the DEP force caused by the electric field. The gap between the first assembling wiring 201 and the second assembling wiring 202 may be smaller than the width of the semiconductor light-emitting element 150 and the width of the assembly hole 207H, and the assembly position of the semiconductor light-emitting element 150 may be fixed more precisely using the electric field.

An insulating layer 215 is formed on the first assembling wiring 201 and the second assembling wiring 202 to protect the first assembling wiring 201 and the second assembling wiring 202 from the fluid 1200 and prevent leakage of current flowing in the first assembling wiring 201 and the second assembling wiring 202. For example, the insulating layer 215 may be formed as a single layer or multiple layers of an inorganic insulator such as silica or alumina or an organic insulator. The insulating layer 215 may have a minimum thickness to prevent damage to the first assembling wiring 201 and the second assembling wiring 202 during assembly of the semiconductor light-emitting element 150, and may have a maximum thickness to stably assemble the semiconductor light-emitting element 150.

A partition wall 207 may be formed on the upper portion of the insulating layer 215. Some areas of the partition wall 207 may be located above the first assembling wiring 201 and the second assembling wiring 202, and the remaining areas may be located above the assembling substrate 200.

Meanwhile, when manufacturing the assembling substrate 200, some of the partition walls formed above the insulating layer 215 may be removed, thereby forming assembly holes 207H in which each of the semiconductor light-emitting elements 150 is coupled and assembled to the assembling substrate 200.

The assembling substrate 200 has assembly holes 207H formed in which the semiconductor light-emitting elements 150 are coupled, and a surface on which the assembly holes 207H are formed may be in contact with the fluid 1200. The assembly holes 207H may guide the exact assembly positions of the semiconductor light-emitting elements 150.

Meanwhile, the assembly holes 207H may have a shape and size corresponding to the shape of the semiconductor light-emitting elements 150 to be assembled at the corresponding positions. Accordingly, it is possible to prevent another semiconductor light-emitting element from being assembled in the assembly hole 207H or a plurality of semiconductor light-emitting elements from being assembled.

After the assembling substrate 200 is disposed in the chamber, an assembly device 1100 that applies a magnetic field can move along the assembling substrate 200. The assembly device 1100 can be a permanent magnet or an electromagnet.

The assembly device 1100 can move in contact with the assembling substrate 200 in order to maximize the area affected by the magnetic field within the fluid 1200. Depending on the embodiment, the assembly device 1100 may comprise a plurality of magnetic bodies or may comprise magnetic bodies of a size corresponding to that of the assembling substrate 200. In this case, the movement distance of the assembly device 1100 may be limited within a predetermined range.

The semiconductor light-emitting element 150 in the chamber 1300 can move toward the assembly device 1100 and the assembling substrate 200 by the magnetic field generated by the assembly device 1100.

The semiconductor light-emitting element 150 can be fixed by entering the assembly hole 207H by the DEP force formed by the electric field between the assembling wirings 201 and 202 while moving toward the assembly device 1100.

Specifically, the first and second assembling wirings 201 and 202 form an electric field by the AC power source, and the DEP force can be formed between the assembling wirings 201 and 202 by this electric field. The semiconductor light-emitting element 150 can be fixed to the assembly hole 207H on the assembling substrate 200 by this DEP force.

At this time, a predetermined solder layer (not shown) may be formed between the light-emitting element 150 assembled on the assembly hole 207H of the assembling substrate 200 and the assembling wiring 201 and 202 to improve the bonding strength of the light-emitting element 150.

In addition, a molding layer (not shown) may be formed on the assembly hole 207H of the assembling substrate 200 after assembly. The molding layer may be a transparent resin or a resin containing a reflective material or a scattering material.

By the self-assembly method using the electromagnetic field described above, the time required for each semiconductor light-emitting element to be assembled on the substrate can be drastically shortened, so that a large-area, high-pixel display can be implemented more quickly and economically.

Meanwhile, although not shown, a Vdd line may be disposed between the first assembling wiring 201 and the second assembling wiring 202 to be used as an electrode wiring for electrically contacting the semiconductor light-emitting element 150.

However, as the semiconductor light-emitting element 150 is miniaturized, the gap between the first assembling wiring 201 and the second assembling wiring 202 also becomes narrower, and when the gap between the first assembling wiring 201 and the second assembling wiring 202 becomes narrower, a problem may occur in which the first assembling wiring 201 or the second assembling wiring 202 is electrically shorted with the Vdd line.

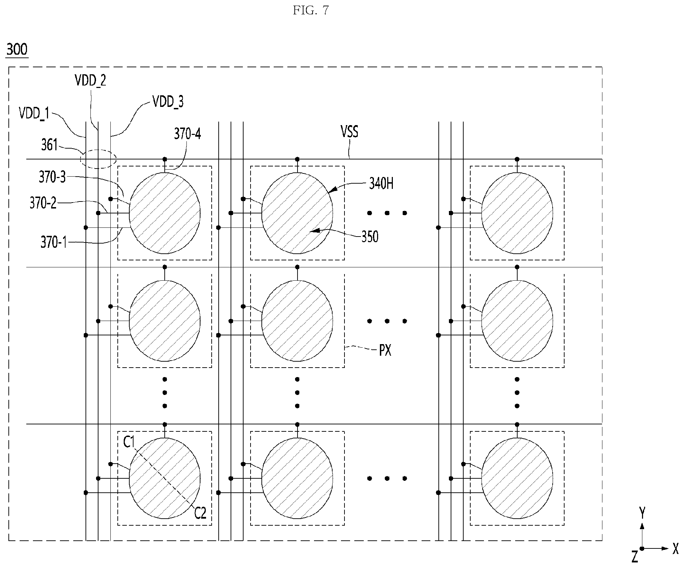

Hereinafter, various embodiments for solving the above-described problem will be described with reference to FIGS. 7 to 14. Any description omitted below can be easily understood from the descriptions given above in relation to FIGS. 1 to 7 and the corresponding drawings.

### [First Embodiment]

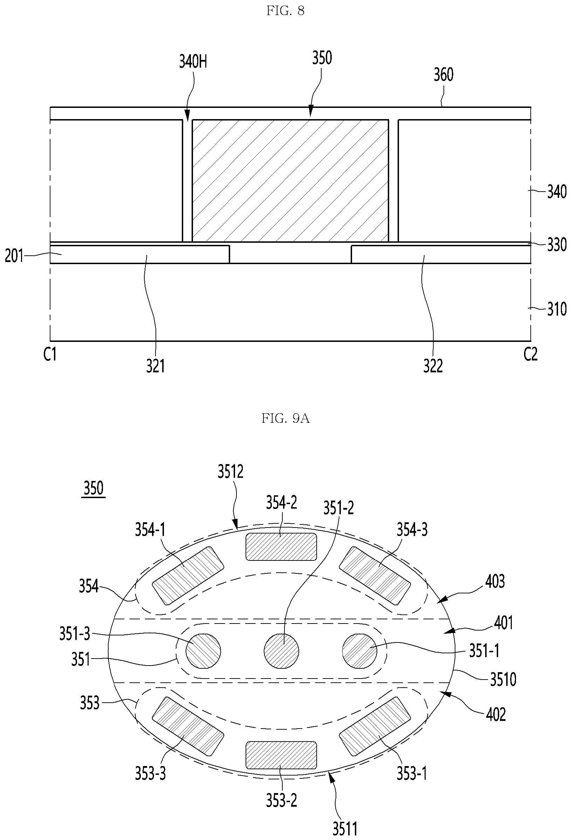

FIG. 7 is a drawing illustrating a display device according to a first embodiment. FIG. 8 is a cross-sectional view taken along the C1-C2 line of the display device according to the first embodiment of FIG. 7.

Referring to FIGS. 7 and 8, the display device 300 according to the first embodiment may comprise a substrate 310, a plurality of light-emitting element packages 350, and a first signal line group 361.

The substrate 310 may serve as a support member supporting various components of the display device 300.

Aplurality of grooves 340H may be provided on the substrate 310. For example, a partition wall 340 may be disposed on the substrate 310, and the plurality of grooves 340H may be formed in the partition wall 340. The grooves 340H may be called assembly holes.

A plurality of pixels PX can be defined on the substrate 310. For example, at least one groove 340H can be provided in one pixel PX. A light-emitting element package 350 can be disposed in the groove 340H of the partition wall 340. Accordingly, at least one light-emitting element package 350 can be provided in one pixel PX.

In the embodiment, a plurality of light-emitting element packages 350 may be assembled into a plurality of grooves 340H using a self-assembly method. To this end, a first assembling wiring 321 and a second assembling wiring 322 may be disposed between the substrate 310 and the partition wall 340, and an insulating layer (330, hereinafter referred to as a first insulating layer) may be disposed on the first assembling wiring 321 and the second assembling wiring 322 to insulate the first assembling wiring 321 and the second assembling wiring 322. In this case, the bottom part of the groove 340H may be a part of an upper surface of the first insulating layer 330. That is, a part of the upper surface of the first insulating layer 330 may be exposed by the groove 340H.

For example, the shape of the groove 340H may correspond to the shape of the light-emitting element package 350. In an embodiment, since the light-emitting element package 350 has an oval shape when viewed from above, the groove 340H may also have an oval shape. For example, the size of the groove 340H may be greater than the size of the light-emitting element package 350. That is, when the light-emitting element package 350 is inserted into the groove 340H, the outer surface of the light-emitting element package 350 may be spaced apart from the inner surface of the groove 340H. The distance between the outer surface of the light-emitting element package 350 and the inner surface of the groove 340H may be 30 µm or less. For example, the distance between the outer surface of the light-emitting element package 350 and the inner surface of the groove 340H may be 200 nm to 20 µm.

According to the embodiment, since the light-emitting element package 350 and the groove 340H have an oval shape, when the light-emitting element package 350 is assembled to the groove 340H, the light-emitting element package 350 may not rotate due to the oval shape of the groove 340H and may maintain the current assembled state, thereby enhancing the fixing force of the light-emitting element package 350.

After the light-emitting element package 350 is assembled to the groove 340H, an insulating layer (360, hereinafter referred to as a second insulating layer) may be formed on the light-emitting element package 350 and the partition wall 340. Although not shown, a black matrix may be disposed between the pixels PX to distinguish between the pixels PX. The black matrix may be disposed on the partition wall 340, excluding the groove 340H, between the partition wall 340 and the second insulating layer 360, but is not limited thereto.

Meanwhile, the light-emitting element package 350 may generate a plurality of different color lights. A color image may be displayed by the plurality of color lights. The plurality of light-emitting element packages 350 may be disposed in the plurality of pixels PX, respectively.

As illustrated in FIG. 9a, the light-emitting element package 350 may comprise a first layer 3510, a first semiconductor light-emitting element group 351, a first electrode pad group 353, and a second electrode pad group 354.

The first layer 3510 may be a support member that supports the first semiconductor light-emitting element group 351, the first electrode pad group 353, and the second electrode pad group 354. As will be described later, the first layer 3510 may be an adhesive member that allows the plurality of semiconductor light-emitting elements 351-1, 351-2, and 351-3 of the first semiconductor light-emitting element group 351 to be easily adhered. The first layer 3510 may be an insulating member. The first layer 3510 may be a rigid member or a flexible member.

The first layer 3510 may have an oval shape. The oval shape of the first layer 3510 may have a minor axis and a major axis. The length of the major axis may be greater than the length of the minor axis. The length may be greatest in the major axis, and the length may be smallest in the minor axis.

The first layer 3510 may comprise a first region 401 comprising a major axis of an oval shape, a second region 402 contacting the first region 401 on one side of the major axis of the oval shape, and a third region 403 contacting the first region 401 on the other side of the major axis of the oval shape.

The second region 402 may have a first round side portion 3511, and the third region 403 may have a second round side portion 3512. In this case, the first round side portion 3511 and the second round side portion 3512 may be symmetrical with respect to the major axis of the oval shape. That is, the curvature of the first round side portion 3511 and the curvature of the second round side portion 3512 may be the same.

The first semiconductor light-emitting element group 351 may be disposed on the first region 401 of the first layer 3510 and may comprise a plurality of semiconductor light-emitting elements 351-1, 351-2, and 351-3. For example, the plurality of semiconductor light-emitting elements 351-1, 351-2, and 351-3 may be disposed along a major axis of the oval shape on the first region 401 of the first layer 3510. That is, the plurality of semiconductor light-emitting elements 351-1, 351-2, and 351-3 may be disposed in a line on the major axis of the oval shape on the first region 401 of the first layer 3510. The first electrode pad group 353 may be disposed on the second region 402 of the first layer 3510 and may comprise a plurality of electrode pads 353-1, 353-2, and 353-3. The second electrode pad group 354 may be disposed on the third region 403 of the first layer 3510 and may comprise a plurality of redundancy electrode pads 354-1, 354-2, and 354-3.

The plurality of semiconductor light-emitting elements 351-1, 351-2, and 351-3 may generate different color lights capable of displaying a color image. For example, the plurality of semiconductor light-emitting elements may comprise a first semiconductor light-emitting element 351-1 that emits a first color light, a second semiconductor light-emitting element 351-2 that emits a second color light, and a third semiconductor light-emitting element 351-3 that emits a third color light. For example, the first color light may comprise red light, the second color light may comprise green light, and the third color light may comprise blue light. In this case, the first semiconductor light-emitting element 351-1, the second semiconductor light-emitting element 351-2, and the third semiconductor light-emitting element 351-3 may be disposed in a line on the major axis of the oval shape. That is, the second semiconductor light-emitting element 351-2 may be positioned between the first semiconductor light-emitting element 351-1 and the third semiconductor light-emitting element 351-3.

The plurality of electrode pads may comprise first to third electrode pads 353-1, 353-2, and 353-3, which are respectively connected to the first to third semiconductor light-emitting elements 351-1, 351-2, and 351-3. For example, the first electrode pad 353-1 may be electrically connected to one side of the first semiconductor light-emitting element 351-1, the second electrode pad 353-2 may be electrically connected to one side of the second semiconductor light-emitting element 351-2, and the third electrode pad 353-3 may be electrically connected to one side of the third semiconductor light-emitting element 351-3.

The plurality of redundancy electrode pads may comprise first to third redundancy electrode pads 354-1, 354-2, and 354-3, which are respectively connected to the first to third semiconductor light-emitting elements 351-1, 35-2, and 351-3. For example, the first redundancy electrode pad 354-1 may be electrically connected to one side of the first semiconductor light-emitting element 351-1, the second redundancy electrode pad 354-2 may be electrically connected to one side of the second semiconductor light-emitting element 351-2, and the third redundancy electrode pad 354-3 may be electrically connected to one side of the third semiconductor light-emitting element 351-3.

The plurality of electrode pads 353-1, 353-2, and 353-3 and the plurality of redundancy electrode pads 354-1, 354-2, and 354-3 may be disposed on the same layer, but are not limited thereto. For example, the plurality of electrode pads 353-1, 353-2, and 353-3 and the plurality of redundancy electrode pads 354-1, 354-2, and 354-3 may be disposed on the upper surface of the first layer 3510.

The plurality of semiconductor light-emitting elements 351-1, 351-2, and 351-3, the plurality of electrode pads 353-1, 353-2, and 353-3, and the plurality of redundancy electrode pads 354-1, 354-2, and 354-3 may be disposed on the same layer, but are not limited thereto. For example, the plurality of semiconductor light-emitting elements 351-1, 351-2, and 351-3, the plurality of electrode pads 353-1, 353-2, and 353-3, and the plurality of redundancy electrode pads 354-1, 354-2, and 354-3 may be disposed on an upper surface of the first layer 3510.

Among the plurality of semiconductor light-emitting elements 351-1, 351-2 and 351-3, at least one semiconductor light-emitting element 351-2 is disposed at the center of the first region 401 of the first layer 3510, and the plurality of electrode pads 353-1, 353-2 and 353-3 and the plurality of redundancy electrode pads 354-1, 354-2 and 354-3 can be disposed to face each other with the at least one semiconductor light-emitting element 351-2 as the center. In this case, the electrode pads and the redundancy electrode pads disposed to face each other can be connected to the same semiconductor light-emitting element 351-1, 351-2 and 351-3.

The second semiconductor light-emitting element 351-2 may be disposed at the center of the first region 401 of the first layer 3510. In this case, the first electrode pad 353-1 and the second redundancy electrode pad 354-2 may be disposed to face each other with the second semiconductor light-emitting element 351-2 as the center, and the first electrode pad 353-1 and the second redundancy electrode pad 354-2 may be electrically connected to one side of the same semiconductor light-emitting element, that is, the first semiconductor light-emitting element 351-1. The second electrode pad 353-2 and the second redundancy electrode pad 354-2 may be disposed to face each other with the second semiconductor light-emitting element 351-2 as the center, and the second electrode pad 353-2 and the second redundancy electrode pad 354-2 may be electrically connected to one side of the same semiconductor light-emitting element, that is, the second semiconductor light-emitting element 351-2. The third electrode pad 353-3 and the third redundancy electrode pad 354-3 may be disposed to face each other with the second semiconductor light-emitting element 351-2 as the center, and the third electrode pad 353-3 and the third redundancy electrode pad 354-3 may be electrically connected to one side of the same semiconductor light-emitting element, i.e., the third semiconductor light-emitting element 351-3.

Meanwhile, the plurality of electrode pads 353-1, 353-2, and 353-3 may be disposed along the first round side portion 3511 on the second region 402 of the first layer 3510, and the plurality of redundancy electrode pads 354-1, 354-2, and 354-3 may be disposed along the second round side portion 3512 on the third region 403 of the first layer 3510.

Each of the plurality of electrode pads 353-1, 353-2, and 353-3 and each of the plurality of redundancy electrode pads 354-1, 354-2, and 354-3 may have dot shapes spaced apart from each other.

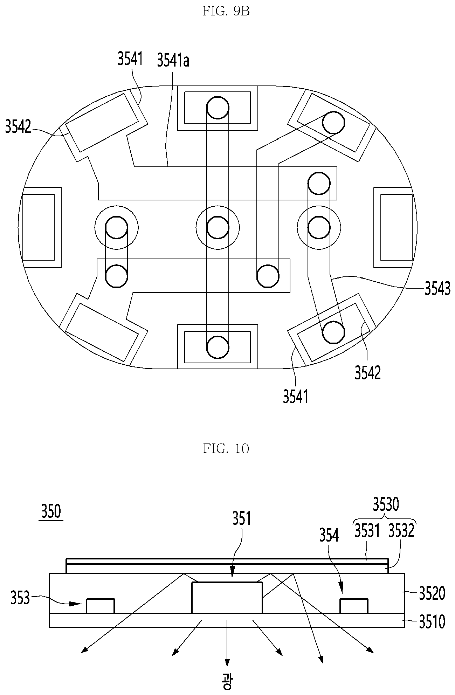

Hereinafter, with reference to FIG. 9b, the connection relationship between the plurality of light-emitting elements, the plurality of electrode pads 353-1, 353-2, and 353-3 and the plurality of redundancy electrode pads 354-1, 354-2, and 354-3 will be described in detail.

As illustrated in FIG. 9b, each of the plurality of electrode pads 353-1, 353-2, and 353-3 and each of the plurality of redundancy electrode pads 354-1, 354-2, and 354-3 may comprise a lower contact electrode 3541 and an upper contact electrode 3542.

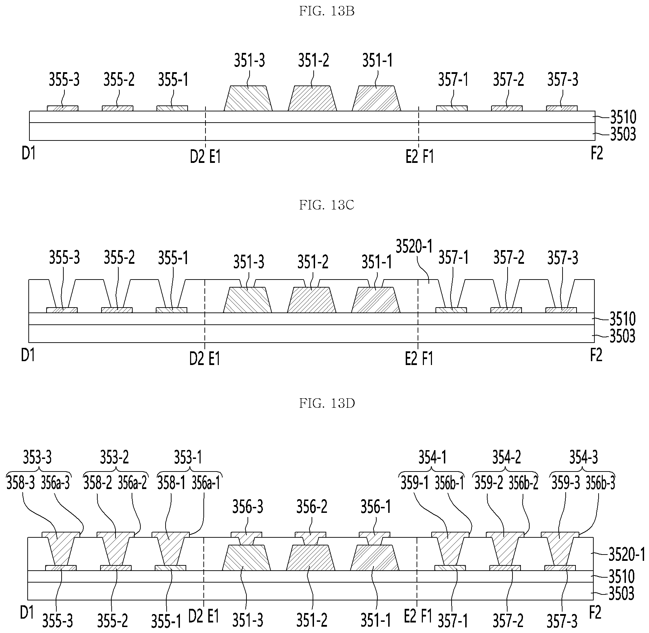

The lower contact electrode 3541 may be disposed on the first layer 3510, and the upper contact electrode 3542 may be disposed on the second-first layer 3520-1 of the second layer (3520 of FIG. 13d). The upper contact electrode 3542 may be electrically connected to the lower contact electrode 3541 through a contact hole.

The upper contact electrode 3542 of each of the plurality of electrode pads 353-1, 353-2, and 353-3 and each of the plurality of redundancy electrode pads 354-1, 354-2, and 354-3 may be electrically connected to one side of each of the first semiconductor light-emitting element 351-1, the second semiconductor light-emitting element 351-2, and the third semiconductor light-emitting element 351-3 through the connection electrode 3543. For example, the upper contact electrode 3542 and the connection electrode 3543 may be integrated. That is, the upper contact electrode 3542 and the connection electrode 3543 may be formed at one time by performing the same photolithography process with the same metal. For example, when a metal film is formed and patterned on the second-first layer 3520-1 of the second layer 3520, the metal film formed in the contact hole among the metal films may be formed as the upper contact electrode 3542, and the metal film extending from the upper contact electrode 3542 to one side of each of the first semiconductor light-emitting element 351-1, the second semiconductor light-emitting element 351-2, and the third semiconductor light-emitting element 351-3 on the second-first layer 3520-1 of the second layer 3520 may be formed as the connection electrode 3543.

Meanwhile, some areas of the lower contact electrode 3541 may be extended to form an extension portion 3541a, and the extension portion 3541a may intersect at least one or more connection electrode 3543. For example, some areas of the lower electrode pad constituting the third electrode pad 353-3 may be extended between the first semiconductor light-emitting element 351-1 and the second semiconductor light-emitting element 351-2 on the second region 402 of the first layer 3510 to form an extension portion 3541a, and the extension portion 3541a and the upper electrode pad constituting the third redundancy electrode pad 354-3 may be electrically connected by the connection electrode 3543. For example, some areas of the lower electrode pad constituting the first redundancy electrode pad 354-1 may be extended to the vicinity of the first semiconductor light-emitting element 351-1 on the third region 403 of the first layer 3510 to form an extension portion 3541a, and the extension portion 3541a and the upper electrode pad constituting the first electrode pad 353-1 may be electrically connected by the connection electrode 3543. At this time, the connection electrode 3543 may also be electrically connected to one side of the first semiconductor light-emitting element 351-1.

Meanwhile, although not shown in FIG. 9A, as shown in FIG. 9B, electrode pads and redundancy electrode pads may be disposed on each side of the major axis of the oval shape of the first layer 3510. The first electrode pad 353-1 and the second electrode pad 353-2, respectively disposed on both sides of the major axis of the oval shape of the first layer 3510, comprise a lower electrode pad and an upper electrode pad that are connected to each other through a contact hole, and can serve as a common electrode pad for commonly connecting to the other sides of each of the first semiconductor light-emitting element 351-1, the second semiconductor light-emitting element 351-2, and the third semiconductor light-emitting element 351-3. In this case, the first electrode pad 353-1 can be included in the first electrode pad group 353, and the second electrode pad 353-2 can be included in the second electrode pad group 354.

Referring again to FIG. 7, the first signal line group 361 can be disposed on one side of each of the plurality of grooves 340H, and can comprise a plurality of signal lines VDD_1, VDD_2, VDD_3, and VSS. Although not shown, a driving transistor (DT in FIG. 3) may be connected between each of the plurality of signal lines VDD_1, VDD_2, VDD_3, and VSS and the pixel PX.

The plurality of signal lines VDD_1, VDD_2, VDD_3, and VSS may be connected to each of the plurality of pixels PX. Each of the plurality of pixels PX may comprise at least one light-emitting element package 350. The light-emitting element package 350 may comprise a first semiconductor light-emitting element group 351 comprising a plurality of semiconductor light-emitting elements 351-1, 351-2, and 351-3. Accordingly, the plurality of signal lines VDD_1, VDD_2, VDD_3, and VSS may be connected to the plurality of semiconductor light-emitting elements 351-1, 351-2, and 351-3.

For example, the plurality of signal lines VDD_1, VDD_2, VDD_3 and VSS may comprise a first signal line VDD_1, a second signal line VDD_2, a third signal line VDD_3 and a fourth signal line VSS.

For example, the first signal line VDD_1, the second signal line VDD_2 and the signal line VDD_3 may be disposed parallel to each other along the second direction Y For example, the fourth signal line VSS may intersect the first signal line VDD_1, the second signal line VDD_2 and the signal line VDD_3 and be disposed along the first direction X. In this case, a pixel PX may be defined by the crossings of the first signal line VDD_1, the second signal line VDD_2, the third signal line VDD_3 and the fourth signal line VSS. Accordingly, a pixel PX can be defined for each crossing area of the first signal line VDD_1, the second signal line VDD_2, the third signal line VDD_3, and the fourth signal line VSS.

The first signal line VDD_1, the second signal line VDD_2, the third signal line VDD_3, and the fourth signal line VSS can be connected to a plurality of semiconductor light-emitting elements 351-1, 351-2, and 351-3 of the light-emitting element package 350 of each pixel PX through a plurality of connection lines 370-1, 370-2, 370-3, and 370-4.

For example, the first signal line VDD_1 may be connected to the first electrode pad 353-1 of the first electrode pad group 353 via the first connection line 370-1, the second signal line VDD_2 may be connected to the second electrode pad 353-2 of the first electrode pad group 353 via the second connection line 370-2, and the third signal line VDD_3 may be connected to the third electrode pad 353-3 of the first electrode pad group 353 via the third connection line 370-3.

For example, the fourth signal line VSS may be connected to the fourth electrode pad of the first electrode pad group 353 (the lower contact electrode 3541 and the upper electrode pad disposed on one side of the major axis of the oval shape in FIG. 9b) via the fourth connection line 370-4. In addition, the connection line 370-4 may connect the fourth electrode pad and the plurality of semiconductor light-emitting elements 351-1, 351-2, and 351-3 on the light-emitting element package 350. That is, the connection line 370-4 may be a connection electrode that commonly connects the plurality of semiconductor light-emitting elements 351-1, 351-2, and 351-3. In other words, the connection line 370-4 may connect the fourth signal line VSS and the fourth electrode pad of the first electrode pad group 353 of the light-emitting element package 350 provided in the pixel PX outside the pixel PX, and may commonly connect the plurality of semiconductor light-emitting elements 351-1, 351-2, and 351-3 of the first semiconductor light-emitting element group 351 of the light-emitting element package 350 inside the pixel PX.

The plurality of connection lines 370-1, 370-2, 370-3, and 370-4 can be formed after the light-emitting element package 350 is assembled into the groove 340H on the substrate 310. That is, after the light-emitting element package 350 is assembled into the groove 340H on the substrate 310, the first connection line 370-1 can be electrically connected to the upper contact electrode 3542 among the lower contact electrode 3541 and the upper contact electrode 3542 constituting the first electrode pad 353-1 of the first electrode pad group 353 of the light-emitting element package 350. The second connection line 370-2 may be electrically connected to the upper contact electrode 3542 among the lower contact electrode 3541 and the upper contact electrode 3542 constituting the second electrode pad 353-2 of the first electrode pad group 353 of the light-emitting element package 350. The third connection line 370-3 may be electrically connected to the upper contact electrode 3542 among the lower contact electrode 3541 and the upper contact electrode 3542 constituting the third electrode pad 353-3 of the first electrode pad group 353 of the light-emitting element package 350.

Meanwhile, the fourth connection line 370-4 may be electrically connected to the upper contact electrode 3542 among the lower contact electrode 3541 and the upper contact electrode 3542 constituting the electrode pads of the light-emitting element package 350 (electrode pads disposed on both sides of the major axis of the oval shape of the first layer 3510 in FIG. 9b). In addition, the fourth connection line 370-4 may be commonly connected to the upper side of each of the plurality of semiconductor light-emitting elements 351-1, 351-2, and 351-3 of the first semiconductor light-emitting element group 351 of the light-emitting element package 350. Although not shown in the drawing, electrode pads may not be disposed on both sides of the oval shape, and the fourth connection line 370-4 may directly connect the fourth signal line VSS of the first signal line group 361 and the upper side of each of the plurality of semiconductor light-emitting elements 351-1, 351-2 and 351-3 of the first semiconductor light-emitting element group 351 of the light-emitting element package 350.

Since the fourth signal line VSS is disposed on the upper sides of the plurality of semiconductor light-emitting elements 351-1, 351-2 and 351-3, the propagation of light of the plurality of semiconductor light-emitting elements 351-1, 351-2 and 351-3 may be impeded. Accordingly, the plurality of connection lines 370-1, 370-2, 370-3, and 370-4 may be made of a conductive material having excellent light transmittance. For example, the connection line 370-4 may comprise ITO or IZO, but is not limited thereto.

As another example, the fourth signal line VSS may be made of a transparent conductive material, and the first signal line VDD_1, the second signal line VDD_2, and the third signal line VDD_3 may be made of a metal having excellent electrical conductivity.

According to an embodiment, when the connection line 370-4 is made of a transparent conductive material, as shown in FIG. 8, when the light-emitting element package 350 is assembled on the substrate 310 in the groove 340H, when the connection line 370-4 that commonly connects the plurality of semiconductor light-emitting elements 351-1, 351-2, and 351-3 of the first semiconductor light-emitting element group 351 is positioned on the front side, different color lights emitted from the plurality of semiconductor light-emitting elements 351-1, 351-2, and 351-3 can be easily emitted forward, thereby preventing a decrease in light efficiency.

Meanwhile, when the groove 340H of the partition wall 340 has an oval shape, the groove 340H of the partition wall 340 can be disposed so that the major axis of the oval shape coincides with the second direction Y, and the minor axis of the oval shape coincides with the first direction X. In this case, when the light-emitting element package 350 is assembled into the groove 340H of the partition wall 340, a plurality of electrode pads 353-1, 353-2 and 353-3 of the first electrode pad group 353 disposed in the second region 402 of the first layer 3510 or a plurality of redundancy electrode pads 354-1, 354-2 and 354-3 of the second electrode pad group 354 disposed in the third region 403 may be disposed adjacent to a plurality of signal lines VDD_1, VDD_2, VDD_3 and VSS of the first signal line group 361.

Accordingly, regardless of whether the plurality of electrode pads 353-1, 353-2 and 353-3 of the first electrode pad group 353 disposed in the second region 402 of the first layer 3510 are disposed adjacent to the plurality of signal lines VDD_1, VDD_2, VDD_3 and VSS of the first signal line group 361 or the plurality of redundancy electrode pads 354-1, 354-2 and 354-3 of the second electrode pad group 354 of the first layer 3510 are disposed adjacent to the plurality of signal lines VDD_1, VDD_2, VDD_3 and VSS of the first signal line group 361, the plurality of signal lines VDD_1, VDD_2, VDD_3 and VSS of the first signal line group 361 and the plurality of electrode pads 351-1, 351-2 and 351-3 of the first electrode pad group 353 or the plurality of redundancy electrode pads 354-1, 354-2 and 354-3 of the second electrode pad group 354 can be easily connected without any obstacle.

According to an embodiment, at least one semiconductor light-emitting element 351-2 among the plurality of semiconductor light-emitting elements 351-1, 351-2 and 351-3 can be disposed at the center of the first region 401 of the first layer 3510, and the plurality of electrode pads 353-1, 353-2 and 353-3 and the plurality of redundancy electrode pads 354-1, 354-2 and 354-3 can be disposed to face each other with the at least one semiconductor light-emitting element 351-2 as the center. In this case, the electrode pads and the redundancy electrode pads disposed to face each other can be connected to the same semiconductor light-emitting element 351-1, 351-2 and 351-3.

Accordingly, even if the light-emitting element package 350 is assembled normally or 180 degrees rotated in the groove 340H of the substrate 310, the plurality of signal lines VDD_1, VDD_2, VDD_3 and VSS disposed on the substrate 310 can be connected to the plurality of electrode pads 353-1, 353-2 and 353-3 or the plurality of redundancy electrode pads 354-1, 354-2 and 354-3 disposed to face each other with the semiconductor light-emitting element 351-2 located at the center of the light-emitting element package 350. Therefore, since the plurality of semiconductor light-emitting elements 351-1, 351-2, and 351-3 of the light-emitting element package 350 are always electrically connected to the plurality of signal lines VDD_1, VDD_2, VDD_3, and VSS disposed on the substrate 310 regardless of the assembly directionality, electrical connection failure that may be caused by the light-emitting element package 350 having an oval shape can be fundamentally blocked.

According to the embodiment, since the light-emitting element package 350 and the groove 340H of the partition wall 340 have an oval shape, when the light-emitting element package 350 is assembled into the groove 340H of the partition wall 340, rotation within the groove 340H of the partition wall 340 can be prevented, thereby enhancing the fixation of the light-emitting element package 350.

According to an embodiment, when the light-emitting element package 350 is assembled into the groove 340H of the partition wall 340 regardless of the direction in which it rotates during the self-assembly process, electrical connection is possible regardless of the assembly directionality, so that the degree of freedom in the assembly directionality can be maximized.

According to an embodiment, a light-emitting element package 350 comprising a plurality of semiconductor light-emitting elements 351-1, 351-2, and 351-3 that constitute one pixel PX may be made in advance, and the light-emitting element package 350 may be assembled by a self-assembly method to implement a display device 300, so that the assembly speed can be dramatically improved, and mass production can be possible.

According to an embodiment, there is no need to individually assemble a plurality of semiconductor light-emitting elements 351-1, 351-2, and 351-3 that emit different color light by a self-assembly method, so that a reduction in color reproducibility can be prevented and full color image implementation can be possible through color mixing prevention.

According to an embodiment, by disposing a light-emitting element package 350 comprising a plurality of semiconductor light-emitting elements 351-1, 351-2, and 351-3 in one pixel PX, the pixel PX size can be reduced to implement ultra-high resolution.

According to an embodiment, by optimizing the arrangement layout of the plurality of semiconductor light-emitting elements 351-1, 351-2, and 351-3 and the plurality of electrode pads 353-1, 353-2, and 353-3, the sizes of each of the plurality of semiconductor light-emitting elements 351-1, 351-2, and 351-3 can be expanded, and the luminance can be increased by the size expansion, thereby implementing a high-quality image.

Meanwhile, as illustrated in FIG. 10, the second layer 3520 may be disposed on the first semiconductor light-emitting element group 351, the first electrode pad group 353, and the second electrode pad group 354, and the metal layer 3530 may be disposed on the second layer 3520.

The second layer 3520 may be a protective layer protecting the first semiconductor light-emitting element group 351, the second electrode pad group 354, and the second electrode pad group 354. The second layer 3520 may be an insulating member. The first layer 3510 may be a rigid member or a flexible member. The second layer 3520 may comprise a plurality of insulating layers. The second layer 3520 may be made of an organic material, but is not limited thereto.

The metal layer 3530 may comprise a plurality of layers.

As an example, the metal layer 3530 may comprise a magnetic layer 3531. The magnetic layer may be made of a magnetic material that can be magnetized by the magnetic member. For example, the magnetic layer may comprise nickel (Ni) or cobalt (Co), but is not limited thereto.

The magnetic member may comprise a plurality of magnetic members disposed parallel to the substrate 310 as the assembly device 1100 illustrated in FIG. 6, or may comprise a single magnetic member having a size corresponding to the size of the substrate 310. The plurality of light-emitting element packages 350 in the fluid may move along the direction in which the magnetic member moves. That is, since the magnetic layer of the light-emitting element package 350 is magnetized by the magnetic field of the magnetic member and is affected by the magnetic field of the magnetic member, when the magnetic member moves, the light-emitting element package 350 may be affected by the magnetic field of the magnetic member and may move along the direction in which the magnetic member moves.

Meanwhile, since the size of the light-emitting element package 350 is relatively large, the magnetization of the magnetic layer must be large so that the light-emitting element package 350 can move according to the movement of the magnetic member. To this end, the magnetic layer may be thickened, or the magnetic layer may be disposed not only on the upper side of the second layer 3520 but also on the side portion of the second layer 3520. In addition, roughness may be formed on the surface of the magnetic layer exposed to the outside, so that the lower surface of the light-emitting element package 350, i.e., the lower surface of the magnetic layer, is not attached to a lower surface of the chamber 1300 illustrated in FIG. 6 during the self-assembly process, thereby significantly increasing the assembly rate and assembly speed.

The metal layer 3530 may comprise a reflective layer 3532. The reflective layer 3532 may be made of a metal with excellent reflectivity. For example, the reflective layer 3532 may comprise aluminum (Al) or silver (Ag), but is not limited thereto.

As illustrated in FIG. 10, light emitted from each of the plurality of semiconductor light-emitting elements 351-1, 351-2, and 351-3 of the first semiconductor light-emitting element group 351 of the light-emitting element package 350 and transmitted to the metal layer 3530 may be reflected by the reflective layer 3532of the metal layer 3530 and emitted to the outside through the first layer 3510. In this way, light emitted from each of the plurality of semiconductor light-emitting elements 351-1, 351-2, and 351-3 of the first semiconductor light-emitting element group 351 of the light-emitting element package 350 may be reflected to increase light efficiency, thereby enabling implementation of a high-luminance display.

Although the drawing shows that the reflective layer is disposed between the magnetic layer and the second layer 3520, the magnetic layer may be disposed between the reflective layer and the second layer 3520. In this case, the magnetic layer may have a very thin thickness so that light can be transmitted.

Meanwhile, the second layer 3520 and the metal layer 3530 may each have a shape corresponding to the shape of the first layer 3510, but is not limited thereto. For example, the second layer 3520 and the metal layer 3530 may each have an oval shape.

The drawing shows the size of the metal layer 3530 to be smaller than the size of the second layer 3520, but it may be the same size as the second layer 3520.

### [Second embodiment]

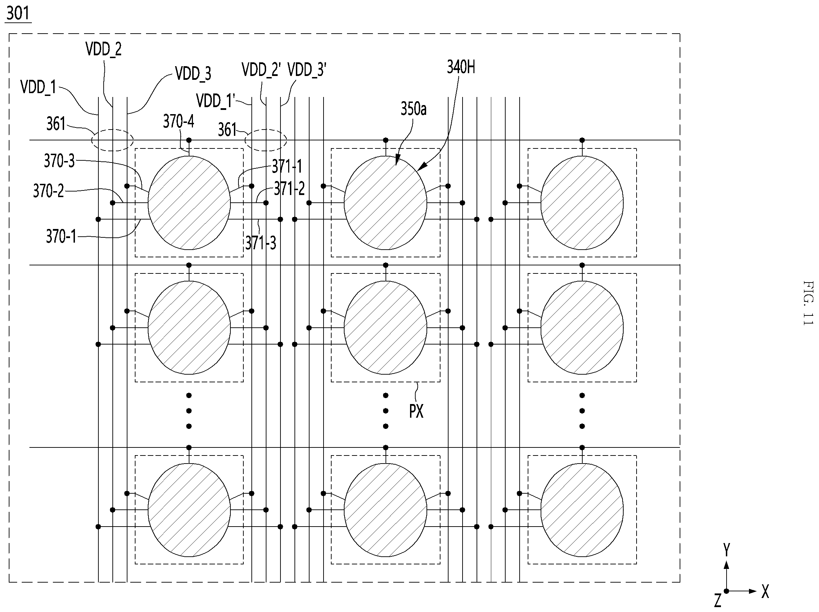

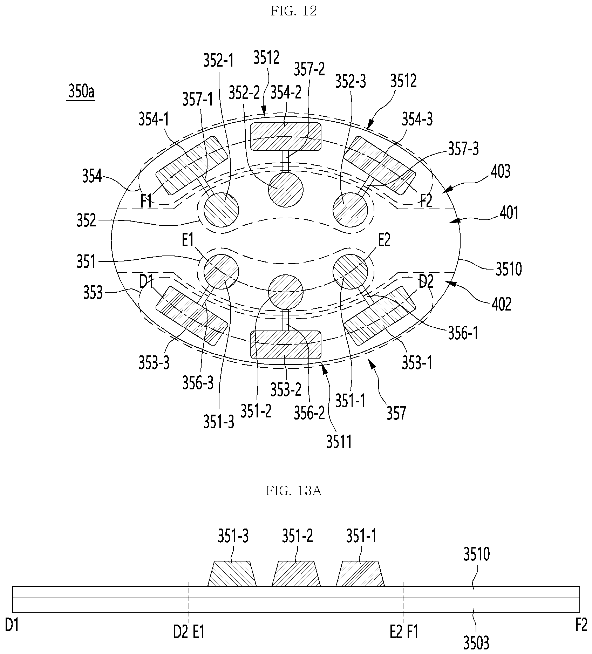

FIG. 11 is a drawing illustrating a display device according to a second embodiment. FIG. 12 is a cross-sectional view schematically illustrating a light-emitting element package according to the second embodiment.

The second embodiment is the same as the first embodiment except for the second signal line group 362 and the second semiconductor light-emitting element group 352. In the second embodiment, components having the same shape, structure, and/or function as those of the first embodiment are given the same drawing reference numerals and detailed descriptions are omitted.

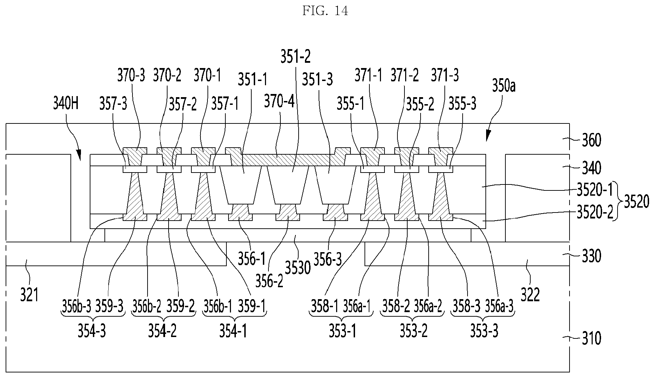

Referring to FIG. 11 and FIG. 12, the display device 301 according to the second embodiment may comprise a substrate (310 of FIG. 14), a plurality of light-emitting element packages 350a, a first signal line group 361, and a second signal line group 362.

Since the substrate 310 and the first signal line group 361 have been described in the first embodiment, a detailed description thereof will be omitted.

Unlike the first embodiment, in the second embodiment, in addition to the first signal line group 361, a second signal line group 362 is added, so that a plurality of redundancy signal lines VDD'-1, VDD'-2, VDD'-3 and VSS' of the second signal line group 362 can have a redundancy function through electrical connection with a plurality of redundancy semiconductor light-emitting elements 352-1, 352-2 and 353-3 of the light-emitting element package 350a. That is, when at least one semiconductor light-emitting element among the plurality of semiconductor light-emitting elements 351-1, 351-2, and 351-3 of the first semiconductor light-emitting element group 351 is broken or defective, among the plurality of redundancy semiconductor light-emitting elements 352-1, 352-2 and 353-3 of the second semiconductor light-emitting element group 352, the redundancy semiconductor light-emitting elements 352-1, 352-2 and 353-3 that emit light of the same color as that of a broken or defective semiconductor light-emitting element may be electrically connected to corresponding redundancy signal lines among the plurality of signal lines VDD_1, VDD_2, VDD_3 and VSS of the second signal line group 362, so that the redundancy semiconductor light-emitting elements 352-1, 352-2 and 353-3 can emit light of the same color as that of the broken or defective semiconductor light-emitting element.

This redundancy function can be used in a repair process when a semiconductor light-emitting element is broken or defective during an inspection process after the electrode connection process is completed, as well as in a self-assembly process, but is not limited thereto.

The second signal line group 362 may comprise a plurality of redundancy signal lines VDD'-1, VDD'-2, VDD'-3, and VSS'. For example, the plurality of redundancy signal lines VDD'-1, VDD'-2, VDD'-3, and VSS' may comprise a first redundancy signal line VDD'-1, a second redundancy signal line VDD'-2, a third redundancy signal line VDD'-3, and a fourth redundancy signal line VSS'.

For example, the first redundancy signal line VDD'-1, the second redundancy signal line VDD'-2, and the third redundancy signal line VDD'-3 may be disposed parallel to each other along the second direction Y For example, the fourth signal line VSS may intersect the first redundancy signal line VDD'-1, the second redundancy signal line VDD'-2, and the third redundancy signal line VDD'-3 and be disposed along the first direction X. The fourth signal line VSS may be commonly included in the first signal line group 361 and the second signal line group 362. Although not illustrated, the fourth signal line VSS may also be individually included in the first signal line group 361 and the second signal line group 362. In this case, the fourth signal line VSS included in the first signal line group 361 may be located on the first side of the pixel PX, and the fourth signal line VSS included in the second signal line group 362 may be located on the second side of the pixel PX.

Meanwhile, unlike the first embodiment, in the second embodiment, as illustrated in FIG. 12, in addition to the first semiconductor light-emitting element group 351, a second semiconductor light-emitting element group 352 is added, so that when at least one semiconductor light-emitting element among the plurality of semiconductor light-emitting elements 351-1, 351-2, and 351-3 of the first semiconductor light-emitting element group 351 is broken or defective, a corresponding semiconductor light-emitting element among the plurality of redundancy semiconductor light-emitting elements 352-1, 352-2, and 353-3 of the second semiconductor light-emitting element group 352 may be electrically connected to the corresponding redundancy signal line of the second signal line group 362 instead of the broken or defective semiconductor light-emitting element, thereby emitting the same color light as the color light of the broken or defective semiconductor light-emitting element, thereby preventing full color defects and enhancing the reliability of the product.

Meanwhile, the unexplained symbols 371-1, 371-2, and 371-3 illustrated in FIG. 12 are redundancy connection lines that can connect a plurality of signal lines VDD'_1, VDD'_2, and VDD'_3 of the second signal line group 362 and a plurality of redundancy electrode pads 354-1, 354-2, and 354-3 of the second electrode pad group 353 of the light-emitting element package 350a.

The omitted description related to FIG. 12 below can be easily understood from the related descriptions of FIGS. 9A and 9B described above.

The light-emitting element package 350a may have an oval shape. Specifically, the first layer 3510 may have an oval shape. The groove 340H on the substrate 310 may have an oval shape and a size greater than the size of the light-emitting element package 350a. For example, the major axis of the groove 340H may be positioned parallel to the second direction Y When the light-emitting element package 350a is assembled to the groove 340H, the major axis of the light-emitting element package 350a may also be positioned parallel to the second direction Y

In this case, the second region 402 or the third region 403 of the light-emitting element package 350a assembled to the groove 340H may be positioned adjacent to the first signal line VDD_1, the second signal line VDD_2, and the third signal line VDD_3 of the first signal line group 361. Accordingly, a plurality of semiconductor light-emitting elements 351-1, 351-2 and 351-3 on the second region 402 of the light-emitting element package 350a can be electrically connected to a plurality of signal lines VDD-1, VDD-2 and VDD-3 of the first signal line group 361 via a plurality of electrode pads 353-1, 353-2 and 353-3 of the first electrode pad group 353 or a plurality of redundancy semiconductor light-emitting elements 352-1, 352-2 and 353-3 on the third region 403 via a plurality of redundancy electrode pads 354-1, 354-2 and 354-3 of the second electrode pad group 354.

The light-emitting element package 350amay comprise a first semiconductor light-emitting element group 351, a second semiconductor light-emitting element group 352, a first signal line group 361, and a second signal line group 362. These components, i.e., the first semiconductor light-emitting element group 351, the second semiconductor light-emitting element group 352, the first signal line group 361, and the second signal line group 362, may be disposed on the first layer 3510.

The first semiconductor light-emitting element group 351 may comprise a plurality of semiconductor light-emitting elements 351-1, 351-2, and 351-3. The second semiconductor light-emitting element 351-2 may comprise a plurality of redundancy semiconductor light-emitting elements 352-1, 352-2, and 353-3. The first signal line group 361 may comprise a plurality of signal lines VDD_1, VDD_2, VDD_3, and VSS. The second signal line group 362 may comprise a plurality of redundancy signal lines VDD'-1, VDD'-2, VDD'-3, and VSS'.

The first semiconductor light-emitting element group 351 and the second semiconductor light-emitting element group 352 may be disposed on the first region 401 of the first layer 3510, the first signal line group 361 may be disposed on the second region 402 of the first layer 3510, and the second signal line group 362 may be disposed on the third region 403 of the first layer 3510.

A plurality of semiconductor light-emitting elements 351-1, 351-2 and 351-3 of the first semiconductor light-emitting element group 351 and a plurality of redundancy semiconductor light-emitting elements 352-1, 352-2 and 353-3 of the second semiconductor light-emitting element group 352 may be disposed in a closed loop shape on the first region 401 of the second layer 3520. At this time, the closed loop shape may have a circular or elliptical shape.

For example, each of the plurality of semiconductor light-emitting elements 351-1, 351-2, and 351-3 of the first semiconductor light-emitting element group 351 may be disposed to be spaced apart from the center of the first layer 3510 by the same or similar distances toward the second region 402. In this case, the distances between the plurality of semiconductor light-emitting elements 351-1, 351-2 and 351-3 of the first semiconductor light-emitting element group 351 and the plurality of electrode pads 353-1, 353-2 and 353-3 of the first electrode pad group 353 may be the same, but are not limited thereto.

For example, each of the plurality of redundancy semiconductor light-emitting elements 352-1, 352-2, and 353-3 of the second semiconductor light-emitting element group 352 may be disposed at the same or similar distances from the center of the first layer 3510 toward the third region 403. In this case, the distances between the plurality of redundancy semiconductor light-emitting elements 352-1, 352-2 and 353-3 of the second semiconductor light-emitting element group 352 and the plurality of redundancy electrode pads 354-1, 354-2 and 354-3 of the second electrode pad group 354 may be the same, but are not limited thereto.

For example, the plurality of semiconductor light-emitting elements 351-1, 351-2, and 351-3 of the first semiconductor light-emitting element group 351 may be connected to the plurality of electrode pads 353-1, 353-2, and 353-3 of the first electrode pad group 353, respectively. The plurality of redundancy semiconductor light-emitting elements 352-1, 352-2 and 353-3 of the second semiconductor light-emitting element group 352 may be respectively connected to a plurality of redundancy electrode pads 354-1, 354-2 and 354-3 of the second electrode pad group 354, but is not limited thereto.

As an example, when it is desired to implement a high-luminance display by emitting light from both the plurality of semiconductor light emitting elements 351-1, 351-2 and 351-3 of the first semiconductor light emitting element group 351 and the plurality of redundancy semiconductor light emitting elements 352-1, 352-2 and 353-3 of the second semiconductor light emitting element group 352, the plurality of semiconductor light-emitting elements 351-1, 351-2, and 351-3 of the first semiconductor light-emitting element group 351 may be respectively connected to the plurality of electrode pads 353-1, 353-2, and 353-3 of the first electrode pad group 353, and the plurality of redundancy light-emitting elements of the second semiconductor light-emitting element group 352 may be respectively connected to the plurality of redundancy electrode pads 354-1, 354-2, and 354-3 of the second electrode pad group 354.

As another example, when it is desired to use the plurality redundancy semiconductor light-emitting elements 352-1, 352-2 and 353-3 of the second semiconductor light-emitting element group 352 as a redundancy function, the plurality of semiconductor light-emitting elements 351-1, 351-2 and 351-3 of the first semiconductor light-emitting element group 351 may be respectively connected to the plurality of electrode pads 353-1, 353-2 and 353-3 of the first electrode pad group 353. After the light-emitting element package 350a is assembled and electrical connection is performed by a post-process, if at least one semiconductor light-emitting element among the plurality of semiconductor light-emitting elements 351-1, 351-2 and 351-3 of the first semiconductor light-emitting element group 351 of the light-emitting element package 350a is broken or defective in an inspection process, a repair process may be performed.

By this repair process, a semiconductor light-emitting element that emits the same color light as the color light of the broken or defective semiconductor light-emitting element among the plurality of redundancy semiconductor light-emitting elements 352-1, 352-2 and 353-3 of the second semiconductor light-emitting element group 352 can be connected to the corresponding redundancy electrode pad of the second electrode pad group 354. Therefore, even if at least one of the plurality of semiconductor light-emitting elements 351-1, 351-2, and 351-3 of the first semiconductor light-emitting element group 351 is broken or defective, by the repair process, among the plurality of redundancy semiconductor light-emitting elements 352-1, 352-2 and 353-3 of the second semiconductor light-emitting element group 352, corresponding redundancy semiconductor light-emitting elements 352-1, 352-2 and 353-3 can be electrically connected to emit light of the same color as that of the broken or defective semiconductor light-emitting element, thereby preventing full color defects.

FIGS. 13A to 13F are flowcharts explaining a manufacturing process of a light-emitting element package according to the second embodiment.

In the first embodiment (FIGS. 7 and 8), the manufacturing process of the light-emitting element package 350 was not described, but the first embodiment can be easily understood from the description of the manufacturing process of the light-emitting element package 350a according to the second embodiment.

As illustrated in FIG. 13A, a first layer 3510 may be formed on a substrate 3503, and a plurality of semiconductor light-emitting elements 351-1, 351-2, and 351-3 may be formed on a second layer 3520. The drawing illustrates a plurality of semiconductor light-emitting elements 351-1, 351-2 and 351-3 constituting the first semiconductor light-emitting element group 351, but a plurality of redundancy semiconductor light-emitting elements 352-1, 352-2 and 353-3 constituting the second semiconductor light-emitting element group 352 may also be formed on the first layer 3510.

For example, the substrate 3503 may be formed of a glass material, but is not limited thereto. The first layer 3510 may be formed of an adhesive material.

For example, a plurality of semiconductor light-emitting elements 351-1, 351-2, and 351-3 may be bonded onto the first layer 3510 using a transfer process. The plurality of semiconductor light-emitting elements may comprise a first semiconductor light-emitting element 351-1 that emits a first color light, a second semiconductor light-emitting element 351-2 that emits a second color light, and a third semiconductor light-emitting element 351-3 that emits a third color light.

For example, a plurality of first semiconductor light-emitting elements 351-1 may be formed on a first substrate using a deposition process, a plurality of second semiconductor light-emitting elements 351-2 may be formed on a second substrate using a deposition process, and a plurality of third semiconductor light-emitting elements 351-3 may be formed on a third substrate using a deposition process. Thereafter, each of the first semiconductor light-emitting element 351-1 on the first substrate, the second semiconductor light-emitting element 351-2 on the second substrate, and the third semiconductor light-emitting element 351-3 on the third substrate may be transferred to the first layer 3510, as illustrated in FIG. 13a. The first substrate, the second substrate, and the third substrate may be growth substrates for growing the first semiconductor light-emitting element 351-1, the second semiconductor light-emitting element 351-2, and the third semiconductor light-emitting element 351-3.

As illustrated in FIG. 13b, a plurality of lower contact electrodes 355-1, 355-2, 355-3, 357-1, 357-2, and 357-3 may be formed on the first layer 3510 using a photolithography process.

As illustrated in FIG. 13c, a second-first layer 3520-1 can be formed on the first semiconductor light-emitting element group 351, the second semiconductor light-emitting element group 352, the first electrode pad group 353, and the second electrode pad group 354, and a plurality of contact holes can be formed using a pattern process. The upper side of each of a plurality of semiconductor light-emitting elements 351-1, 351-2 and 351-3 of the first semiconductor light-emitting element group 351, each of a plurality of redundancy semiconductor light-emitting elements 352-1, 352-2 and 353-3 of the second semiconductor light-emitting element group 352, each of a plurality of electrode pads 353-1, 353-2 and 353-3 of the first electrode pad group 353, and each of a plurality of redundancy electrode pads 354-1, 354-2 and 354-3 of the second electrode pad group 354 can be exposed to the outside by a plurality of contact holes.

As illustrated in FIG. 13d, a plurality of upper contact electrodes 358-1, 358-2, 358-3, 359-1, 359-2, and 359-3 and a plurality of connection electrodes 356a-1, 356a-2, 356a-3, 356b-1, 356b-2, and 356b-3 can be formed on the second-first layer 3520-1.

The lower contact electrodes 355-1, 355-2, 355-3, 357-1, 357-2, and 357-3 and the upper contact electrodes 358-1, 358-2, 358-3, 359-1, 359-2, and 359-3 can be electrically connected in the contact holes of the second-first layer 3520-1. For example, the lower contact electrodes 355-1, 355-2, 355-3, 357-1, 357-2, and 357-3 and the upper contact electrodes 358-1, 358-2, 358-3, 359-1, 359-2, and 359-3 can be made of a metal having excellent electrical conductivity, and can be composed of a plurality of layers.

The upper contact electrodes 358-1, 358-2, 358-3, 359-1, 359-2, and 359-3 and the connection electrodes 356a-1, 356a-2, 356a-3, 356b-1, 356b-2, and 356b-3 may be formed integrally. For example, the connection electrodes 356a-1, 356a-2, 356a-3, 356b-1, 356b-2, and 356b-3 may extend from the upper contact electrodes 358-1, 358-2, 358-3, 359-1, 359-2, and 359-3.

Each of a plurality of electrode pads 353-1, 353-2 and 353-3, and each of a plurality of redundancy electrode pads 354-1, 354-2 and 354-3 may be formed by lower contact electrodes 355-1, 355-2, 355-3, 357-1, 357-2 and 357-3 and upper contact electrodes 358-1, 358-2, 358-3, 359-1, 359-2 and 359-3.

A plurality of electrode pads 353-1, 353-2 and 353-3 and one sides of a plurality of semiconductor light-emitting elements 351-1, 351-2 and 351-3 may be electrically connected to each other by a plurality of connection electrodes 356a-1, 356a-2, 356a-3, 356b-1, 356b-2 and 356b-3, and a plurality of redundancy electrode pads 354-1, 354-2 and 354-3 and a plurality of redundancy semiconductor light-emitting elements 352-1, 352-2 and 353-3 may be electrically connected to each other by a plurality of connection electrodes 356a-1, 356a-2, 356a-3, 356b-1, 356b-2 and 356b-3. As described above, the plurality of semiconductor light-emitting elements 351-1, 351-2, and 351-3 may constitute a first semiconductor light-emitting element group 351, the plurality of redundancy semiconductor light-emitting elements 352-1, 352-2, and 353-3 may constitute a second semiconductor light-emitting element group 352, the plurality of electrode pads 353-1, 353-2, and 353-3 may constitute a first electrode pad group 353, and the plurality of redundancy electrode pads 354-1, 354-2, and 354-3 may constitute a second electrode pad group 354.

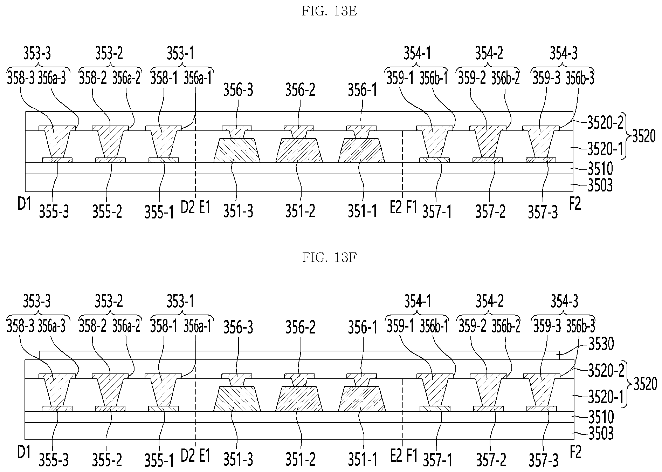

As illustrated in FIG. 13e, a second-second layer 3520-2 may be formed on a plurality of upper contact electrodes 358-1, 358-2, 358-3, 359-1, 359-2, and 359-3 and a plurality of connection electrodes 356a-1, 356a-2, 356a-3, 356b-1, 356b-2, and 356b-3. The second layer 3520 may be formed by the second-first layer 3520-1 and the second-second layer 3520-2.

The second-second layer 3520-2 may be a protective layer protecting the second-second layer 3520-2 on the plurality of upper contact electrodes 358-1, 358-2, 358-3, 359-1, 359-2, and 359-3 and the plurality of connection electrodes 356a-1, 356a-2, 356a-3, 356b-1, 356b-2, and 356b-3. The second-second layer 3520-2 may be a planarizing layer for easily forming another layer or pattern by a post-process.

The second-first layer 3520-1 and the second-second layer 3520-2 may be made of the same material or different materials. For example, the second-first layer 3520-1 and the second-second layer 3520-2 may be formed of organic materials. For example, the second-first layer 3520-1 may be formed of organic materials, and the second-second layer 3520-2 may be formed of inorganic materials.

As illustrated in FIG. 13f, a metal layer 3530 may be formed on the second-second layer 3520, that is, the second-second layer 3520-2.

The metal layer 3530 may comprise a plurality of layers.

For example, a reflective layer (3532 of FIG. 10) may be formed on the second-second layer 3520-2, and a magnetic layer 3531 may be formed on the reflective layer, but this is not limited thereto.

Although not shown, the second layer 3520 and the first layer 3510 on the substrate 3503 may be removed to form a plurality of light-emitting element packages 350a, and the plurality of regions can be separated individually by removing the substrate 3503. At this time, each of the plurality of regions can become a light-emitting element package 350a.

The light-emitting element package 350a can be manufactured by the manufacturing process described above.

The manufactured light-emitting element package 350a is assembled into the groove 340H of each pixel PX illustrated in FIG. 11, and a post-process is performed, so that the display device 301 according to the second embodiment can be manufactured.

Referring to FIG. 14, the display device 301 according to the second embodiment will be described.

FIG. 14 is a cross-sectional view illustrating a display device equipped with a light-emitting element package according to the second embodiment. That is, FIG. 14 is a cross-sectional view illustrating a unit pixel of a display device according to the second embodiment.

Referring to FIG. 11 and FIG. 14, the light-emitting element package 350a manufactured by FIG. 13a to FIG. 13f may be disposed in the groove 340H of the substrate 310.

After the light-emitting element package 350a is assembled in the groove 340H of the substrate 310 by the self-assembly process, a plurality of connection lines 370-1, 370-2, 370-3, and 370-4 may be formed.

The plurality of signal lines VDD_1, VDD_2, VDD_3 and VSS of the first signal line group 361 can be electrically connected to the plurality of electrode pads 353-1, 353-2 and 353-3 of the first electrode pad group 353 of the light-emitting element package 350a by the plurality of connection lines 370-1, 370-2, 370-3 and 370-4.

In particular, the fourth connection line 370-4 can commonly connect the fourth signal line VSS of the first signal line group 361 and the upper sides of the plurality of semiconductor light-emitting elements 351-1, 351-2 and 351-3 of the first semiconductor light-emitting element group 351 of the light-emitting element package 350a.

An insulating layer 360 can be disposed on the light-emitting element package 350a and the partition wall 340. The light-emitting element package 350a can be protected and fixed by the insulating layer 360. The insulating layer 360 can be made of an organic material, but is not limited thereto.

For example, a high-level voltage from each of the first signal line VDD_1, the second signal line VDD_2, and the third signal line VDD_3 of the first signal line group 361 can be supplied to the lower side of each of the first semiconductor light-emitting element 351-1, the second semiconductor light-emitting element 351-2, and the third semiconductor light-emitting element 351-3 of the first semiconductor light-emitting element group 351 of the light-emitting element package 350a through the connection lines 370-1, 370-2, and 370-3. For example, a low-level voltage from each of the fourth signal lines VSS of the first signal line group 361 can be commonly supplied to the upper side of each of the first semiconductor light-emitting element 351-1, the second semiconductor light-emitting element 351-2, and the third semiconductor light-emitting element 351-3 of the light-emitting element package 350a through the fourth connection line 370-4. Accordingly, the first color light, the second color light, and the third color light may be emitted by each of the first semiconductor light-emitting element 351-1, the second semiconductor light-emitting element 351-2, and the third semiconductor light-emitting element 351-3 of the first semiconductor light-emitting element group 351 of the light-emitting element package 350a, so that a full-color image can be displayed.

For example, the low-level voltage can be 0 V as a ground voltage. In this case, by varying the high-level voltage, the luminance of each of the first color light, the second color light, and the third color light can be varied, thereby expressing grayscale of the image.

Meanwhile, the display device described above may be a display panel. That is, in the embodiment, the display device and the display panel may be understood to have the same meaning. In the embodiment, the display device in a practical sense may comprise a display panel and a controller (or processor) that can control the display panel to display an image.

The above detailed description should not be construed as limiting in all respects and should be considered illustrative. The scope of the embodiment should be determined by reasonable interpretation of the appended claims, and all changes within the equivalent range of the embodiment are included in the scope of the embodiment.

### [Industrial Applicability]

The embodiment can be adopted in the display field for displaying images or information. The embodiment can be adopted in the display field for displaying images or information using a semiconductor light-emitting element. The semiconductor light-emitting element can be a micro-level semiconductor light-emitting element or a nano-level semiconductor light-emitting element.

For example, the embodiment can be adopted in a TV, signage, a smart phone, a mobile phone, a mobile terminal, a HUD for a car, a backlight unit for a notebook, a display device for VR or AR.

## Claims

1. A light-emitting element package, comprising:
a first layer having an oval shape;
a first semiconductor light-emitting element group on the first layer;
a first electrode pad group on the first layer; and
a second electrode pad group on the first layer;
wherein the first layer has a first region comprising a major axis of the oval shape, a second region contacting the first region on one side of the major axis of the oval shape, and a third region contacting the first region on the other side of the major axis of the oval shape,
wherein the first semiconductor light-emitting element group is disposed on the first region and comprises a plurality of semiconductor light-emitting elements,
wherein the first electrode pad group is disposed on the second region and comprises a plurality of electrode pads, and
wherein the second electrode pad group is disposed on the third region and comprises a plurality of redundancy electrode pads.

2. The light-emitting element package of claim 1, wherein the plurality of semiconductor light-emitting elements are disposed along the major axis of the oval shape on the first region.

3. The light-emitting element package of claim 2, wherein at least one semiconductor light-emitting element among the plurality of semiconductor light-emitting elements is disposed at a center of the first region, and
wherein the plurality of electrode pads and the plurality of redundancy electrode pads are disposed to face each other with the at least one semiconductor light-emitting element as the center.

4. The light-emitting element package of claim 3, wherein the electrode pads and the redundancy electrode pads disposed to face each other are connected to a same semiconductor light-emitting element.

5. The light-emitting element package of claim 1, wherein the second region has a first round side, the third region has a second round side, and the first round side and the second round side are symmetrical with respect to the major axis of the oval shape.

6. The light-emitting element package of claim 5, wherein the plurality of electrode pads are disposed along the first round side on the second region, and the plurality of redundancy electrode pads are disposed along the second round side on the third region.

7. The light-emitting element package of claim 1, wherein each of the plurality of electrode pads and each of the plurality of redundancy electrode pads has a dot shape spaced apart from each other.

8. The light-emitting element package of claim 1, comprising:
a second semiconductor light-emitting element group on the first layer, and
wherein the second semiconductor light-emitting element group are disposed on the first region, and comprise a plurality of redundancy semiconductor light-emitting elements.

9. The light-emitting element package of claim 8, wherein the plurality of redundancy semiconductor light-emitting elements are disposed adjacent to the plurality of semiconductor light-emitting elements on the first region.

10. The light-emitting element package of claim 9, wherein the plurality of semiconductor light-emitting elements and the plurality of redundancy semiconductor light-emitting elements are disposed in a closed loop shape.

11. The light-emitting element package of claim 10, wherein the plurality of semiconductor light-emitting elements are respectively connected to the plurality of electrode pads, and
wherein the plurality of redundancy semiconductor light-emitting elements are respectively connected to the plurality of redundancy electrode pads.

12. The light-emitting element package of claim 1, comprising:
a second layer on the first semiconductor light-emitting element group, the first electrode pad group, and the second electrode pad group; and
a metal layer on the second layer.

13. The light-emitting element package of claim 12, wherein the metal layer comprises a magnetic layer.

14. The light-emitting element package of claim 13, wherein the metal layer as a reflective layer.

15. The light-emitting element package of claim 12, wherein the second layer and the metal layer each have a shape corresponding to a shape of the first layer.

16. A display device, comprising:
a substrate comprising a plurality of grooves;
a plurality of light-emitting element packages disposed in the plurality of grooves, respectively; and
a first signal line group disposed on one sides of the plurality of grooves, respectively and comprising a plurality of signal lines,
wherein the light-emitting element package comprises:
a first layer having an oval shape;
a first semiconductor light-emitting element group on the first layer;
a first electrode pad group on the first layer; and
a second electrode pad group on the first layer;
wherein the first layer has a first region comprising the major axis of the oval shape, a second region contacting the first region on one side of the major axis of the oval shape, and a third region contacting the first region on the other side of the major axis of the oval shape,
wherein the first semiconductor light-emitting element group is disposed on the first region and comprises a plurality of semiconductor light-emitting elements,
wherein the first electrode pad group is disposed on the second region and comprises a plurality of electrode pads, and
wherein the second electrode pad group is disposed on the third region and comprises a plurality of redundancy electrode pads.

17. The display device of claim 16, comprising:
a second signal line group disposed on the other sides of the plurality of grooves, respectively and comprising a plurality of redundancy signal lines,
wherein the light-emitting element package comprises:
a second semiconductor light-emitting element group on the first layer; and
wherein the second semiconductor light-emitting element group is disposed on the first region and comprises a plurality of redundancy semiconductor light-emitting elements, and
wherein the plurality of signal lines are connected to the plurality of semiconductor light-emitting elements, respectively.

18. The display device of claim 17, wherein the major axis of the oval shape of the first layer is parallel to the plurality of signal lines and the plurality of redundancy signal lines.

19. The display device of claim 18, wherein the plurality of semiconductor light-emitting elements are disposed adjacent to the plurality of signal lines, and
wherein the plurality of redundancy semiconductor light-emitting elements are disposed adjacent to the plurality of redundancy signal lines.
